(19) Europäisches Patentamt / European Patent Office / Office européen des brevets

(11) **EP 3 235 137 B1**

(12) **FASCICULE DE BREVET EUROPEEN**

(45) Date de publication et mention de la délivrance du brevet:
**12.04.2023  Bulletin 2023/15**

(21) Numéro de dépôt: **15821061.7**

(22) Date de dépôt: **18.12.2015**

(51) Classification Internationale des Brevets (IPC):
**H03M 1/06** *(2006.01)*      **H03M 1/10** *(2006.01)*

(52) Classification Coopérative des Brevets (CPC):
**H03M 1/0614; H03M 1/1033**

(86) Numéro de dépôt international:
**PCT/EP2015/080693**

(87) Numéro de publication internationale:
**WO 2016/097395 (23.06.2016 Gazette 2016/25)**

(54) **PROCÉDÉ DE CORRECTION DES DÉFAUTS D'INTERMODULATION D'UN CIRCUIT DE CONVERSION**

VERFAHREN ZUR KORREKTUR VON INTERMODULATIONSFEHLERN EINER WANDLERSCHALTUNG

METHOD FOR CORRECTING INTERMODULATION ERRORS OF A CONVERSION CIRCUIT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **19.12.2014  FR 1402939**

(43) Date de publication de la demande:
**25.10.2017  Bulletin 2017/43**

(73) Titulaire: **THALES**
**92400 Courbevoie (FR)**

(72) Inventeur: **HODE, Jean-Michel**
**33608 Pessac (FR)**

(74) Mandataire: **Lavoix**
**2, place d'Estienne d'Orves**
**75441 Paris Cedex 09 (FR)**

(56) Documents cités:
**US-A- 5 237 332          US-A- 5 237 332**
**US-A1- 2005 219 089    US-A1- 2005 219 089**
**US-B2- 8 825 415**

- **REBEIZ ERIC ET AL: "Suppressing RF front-end nonlinearities in wideband spectrum sensing", 8TH INTERNATIONAL CONFERENCE ON COGNITIVE RADIO ORIENTED WIRELESS NETWORKS, ICST - THE INSTITUTE FOR COMPUTER SCIENCES, SOCIAL INFORMATICS AND TELECOMMUNICATIONS ENGINEERING, 8 juillet 2013 (2013-07-08), pages 87-92, XP032510473,**
- **REBEIZ ERIC ET AL: "Suppressing RF front-end nonlinearities in wideband spectrum sensing", 8TH INTERNATIONAL CONFERENCE ON COGNITIVE RADIO ORIENTED WIRELESS NETWORKS, ICST - THE INSTITUTE FOR COMPUTER SCIENCES, SOCIAL INFORMATICS AND TELECOMMUNICATIONS ENGINEERING, 8 July 2013 (2013-07-08), pages 87-92, XP032510473, [retrieved on 2013-10-17]**
- **GRIMM MICHAEL ET AL: "Joint Mitigation of Nonlinear RF and Baseband Distortions in Wideband Direct-Conversion Receivers", IEEE TRANSACTIONS ON MICROWAVE THEORY AND TECHNIQUES, IEEE, USA, vol. 62, no. 1, 1 January 2014 (2014-01-01), pages 166-182, XP011536035, ISSN: 0018-9480, DOI: 10.1109/TMTT.2013.2292603 [retrieved on 2014-01-01]**

EP 3 235 137 B1

• **SUNDE E D: "Intermodulation distortion in analog FM troposcatter systems", BELL SYSTEM TECHNICAL JOURNAL, AT AND T, SHORT HILLS, NY, US, vol. 43, no. 1, 1 January 1964 (1964-01-01), pages 399-435, XP011630870, ISSN: 0005-8580, DOI: 10.1002/J.1538-7305.1964.TB04073.X [retrieved on 2014-03-15]**

**Description**

DOMAINE TECHNIQUE DE L'INVENTION

La présente invention concerne un procédé de correction des défauts d'intermodulation introduits par un circuit de conversion et/ou une chaîne de réception se terminant par un tel circuit. L'invention se rapporte également à un produit programme d'ordinateur et un appareil électronique propres à mettre en oeuvre le procédé de correction.

ARRIERE-PLAN TECHNOLOGIQUE

La mise en place d'un traitement par une chaîne de réception unique « partagée » des informations en provenance des nombreux capteurs embarqués sur un avion permet d'augmenter les performances des systèmes tout en réduisant l'encombrement, la consommation d'énergie et le coût de l'électronique embarquée. Pour que ceci soit possible, il convient de numériser le signal très en amont de la chaîne de réception.

Mais, lorsqu'un circuit de conversion propre à convertir un signal analogique d'entrée en un signal numérique de sortie est situé en amont dans la chaîne de réception, la conversion analogique-numérique est une fonction qui dimensionne la performance de la chaîne de réception. Pour la mise en oeuvre d'une telle fonction, il convient de prendre en compte les contraintes souvent antinomiques des besoins en dynamique et en largeur de bande des différents capteurs de l'avion.

Pour cela, il est souhaitable d'obtenir un circuit de conversion travaillant à la fois sur porteuse élevée et avec une fréquence d'échantillonnage élevée pour traiter les besoins en bande large et présentant des caractéristiques dynamiques excellentes pour satisfaire les besoins en bande étroite.

Il est à noter que les deux contraintes précédentes sont antinomiques et que, pour une technologie de réalisation donnée, il n'est possible que d'aboutir à un compromis entre vitesse/bande et dynamique.

De plus, du fait qu'il est envisagé de fonctionner avec une fréquence d'échantillonnage élevée, il apparaît que la maîtrise du plan de fréquences est un élément important pour limiter la non-linéarité du circuit de conversion.

Pour cela, il est constatable que lorsque que la fréquence de fonctionnement $f_0$ est égale au rapport de la fréquence d'échantillonnage $f_{ECH}$ par 5 (c'est-à-dire que $f_0 = f_{ECH}/5$), les harmoniques d'ordre 2 et 3 du signal se replient autour de deux fréquences qui sont $2*f_{ECH}/5$ et $3*f_{ECH}/5$. En outre, l'harmonique d'ordre 5 se replie autour du continu.

Similairement, lorsque la fréquence de fonctionnement $f_0$ est égale au rapport de la fréquence d'échantillonnage $f_{ECH}$ par 8 (c'est-à-dire que $f_0 = f_{ECH}/8$) ou lorsque la fréquence de fonctionnement $f_0$ est égale au rapport du produit de 3 avec la fréquence d'échantillonnage $f_{ECH}$ par 8 (c'est-à-dire que $f_0 = 3*f_{ECH}/8$), l'harmonique d'ordre 2 se replie autour de deux fréquences qui sont $f_{ECH}/4$ et $3*f_{ECH}/4$. De plus, il est constaté que les harmoniques d'ordre 3 et 5 du signal se replient autour d'une fréquence qui est soit $3*f_{ECH}/8$ soit $f_{ECH}/8$. En outre, l'harmonique d'ordre 4 se replie autour de la fréquence qui est $f_{ECH}/2$. De plus, il est constaté que l'harmonique d'ordre 6 du signal se replie autour d'une fréquence qui est soit $3*f_{ECH}/4$ soit $f_{ECH}/4$.

Placer le signal d'entrée autour des fréquences de fonctionnement précitées permet de ne pas être gêné par les parasites induits par les mécanismes de distorsion les plus difficiles à combattre. Cependant, il reste des phénomènes d'intermodulation créant des parasites dans la bande qui ne sont pas filtrés par principe.

Le problème de l'intermodulation se pose lorsqu'un amplificateur amplifie des signaux de forme complexe. On mesure les caractéristiques d'intermodulation d'un amplificateur en appliquant simultanément à l'entrée de celui-ci deux signaux sinusoïdaux, de niveaux identiques, et de fréquences f1 et f2. Si l'amplificateur est parfaitement linéaire, on retrouve sur sa sortie les deux signaux superposés, de fréquences f1 et f2, et seulement ceux-ci. S'il n'est pas parfaitement linéaire, on retrouvera en sortie, d'autres fréquences en plus de f1 et f2. On retrouvera par exemple les fréquences f1+f2, la fréquence f1 - f2, la fréquence 2f1 - f2, et d'une façon générale, on pourra retrouver des signaux présentant une fréquence à n.f1+m.f2 où n et m sont des entiers relatifs. Si n=0, le produit issu de m est une harmonique du signal utile.

En particulier, l'intermodulation d'ordre 3 et l'intermodulation d'ordre 5 sont particulièrement gênantes, l'intermodulation d'ordre 3 présentant en général une amplitude plus importante que l'intermodulation d'ordre 5.

Compte tenu du compromis vitesse/dynamique à obtenir, il est difficile de disposer des convertisseurs présentant des performances dynamiques compatibles avec les impératifs associés aux modes radar les plus résolus. Il est donc souhaitable de corriger par post-traitement les défauts d'ordre 3 ou 5 induits non seulement par le convertisseur, mais aussi par toute la chaîne de réception qui le précède, en retranchant au signal une correction calculée comme une fonction de lui-même.

Usuellement, une telle fonction de correction est issue d'un modèle de distorsion prenant en compte la complexité des défauts de linéarité. Dans le cas de nombreux composants, la fonction de correction choisie est une fonction monôme de degré 3, à savoir que $f(x) = \alpha \times x^3$ en notant f la fonction de correction et $\alpha$ un paramètre de proportionnalité.

Toutefois, un tel type de modèle est inopérant pour un circuit de conversion analogique-numérique du fait que les mécanismes de distorsion mis en jeu sont beaucoup plus complexes que ceux des composants habituels. En effet, le circuit de conversion introduit une erreur à un instant donné dépendant non seulement de la valeur du signal à l'instant donné mais aussi de ses variations et également de sa fréquence.

Pour les circuits de conversion, il est connu du document US 8 825 415 B2 une architecture de correction complexe comportant plusieurs étapes successives de calcul de correction (estimation) et de compensation, chaque estimation s'effectuant sur le signal issu du circuit de conversion. De façon schématique, les calculs afférant à l'une quelconque des estimations s'effectuent comme le calcul parallèle de P corrections (P étant un nombre entier positif) distinctes qui sont ensuite sommées entre chaque estimation et retranchées au signal. Chaque calcul des P corrections comporte successivement un filtre (sélection d'une partie du spectre), une interpolation, une distorsion de type $x^n$ (n variant d'une correction à l'autre), un filtrage et une décimation. L'objet de la correction a donc pour objet l'intégralité du spectre et porte à la fois, du fait du type de distorsion mise en jeu, de la distorsion harmonique et de l'intermodulation.

Cependant, une telle correction n'est pas adaptée pour des signaux en bande étroite sur-échantillonnés. Notamment, une telle correction n'est pas adaptée à un signal dans lequel la distorsion harmonique a été filtrée (séparée de l'intermodulation du fait du plan de fréquence et filtrée par un filtre de décimation). Dans certains cas, l'application d'un tel mécanisme de compensation à un tel signal conduit à générer de la distorsion harmonique non désirée. De plus, mettre en oeuvre une telle compensation implique une charge de calcul très importante du fait des multiples filtrages et interpolations utilisés.

D'autres procédés de correction sont connus de l'article de Eric REBEIZ et al. intitulé « Suppressing RF front-end nonlinearities in wideband spectrum sensing », du document US 5 237 332 A, du document US 2005/219089 A1 et de l'article de Michael GRIMM et al. intitulé « Joint Mitigation of Nonlinear RF and Baseband Distortions in Wideband Direct-Conversion Receivers ».Il existe donc un besoin pour un procédé de correction des défauts d'intermodulation introduits par un circuit de conversion qui permette, avec une mise en oeuvre aisée, de diminuer les défauts d'intermodulation sans générer de la distorsion harmonique non désirée.

RESUME DE L'INVENTION

Pour cela, il est proposé un procédé de correction selon la revendication 1.

Suivant des modes de réalisation particuliers, le procédé comprend une ou plusieurs des caractéristiques 2 à 6, prise(s) isolément ou suivant toutes les combinaisons techniquement possibles.

Il est également proposé un produit programme d'ordinateur comportant un support lisible d'informations, sur lequel est mémorisé un programme d'ordinateur comprenant des instructions de programme, le programme d'ordinateur étant chargeable sur une unité de traitement de données et adapté pour entraîner la mise en oeuvre d'un procédé tel que précédemment décrit lorsque le programme d'ordinateur est mis en oeuvre sur l'unité de traitement des données.

Il est aussi proposée un appareil électronique selon la revendication 8.

Suivant un mode de réalisation particulier, le correcteur est un circuit logique programmable.

BREVE DESCRIPTION DES DESSINS

D'autres caractéristiques et avantages de l'invention apparaîtront à la lecture de la description qui suit de modes de réalisation de l'invention, donnée à titre d'exemple uniquement et en référence aux dessins qui sont :

- figure 1, une représentation schématique d'appareil électronique,
- figure 2, une vue schématique d'un exemple de système permettant la mise en oeuvre d'un procédé de correction, et
- figures 3 à 11, des graphes illustrant des simulations de résultats obtenus après mise en oeuvre d'exemples de procédés de correction.

DESCRIPTION DETAILLEE DE MODES DE REALISATION DE L'INVENTION

*Description d'un exemple d'appareil électronique*

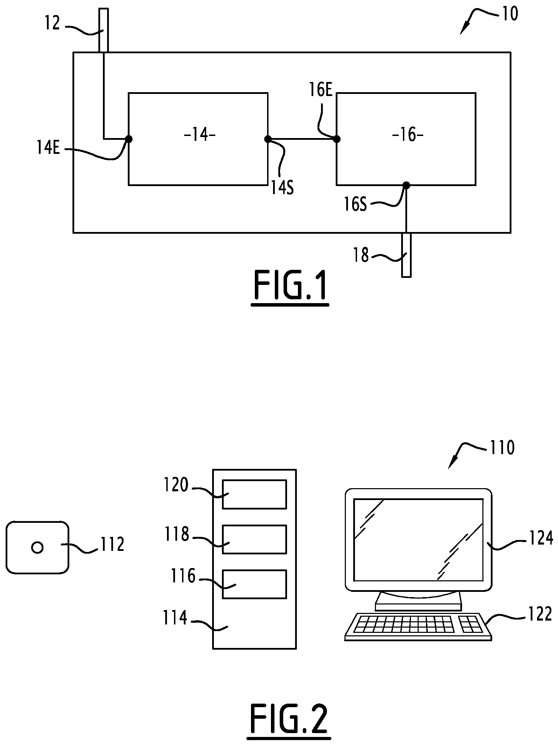

Un appareil électronique 10 est illustré schématiquement à la figure 1.

L'appareil électronique 10 comporte un récepteur 12, un circuit de conversion 14, un correcteur 16 et un émetteur 18.

Le récepteur 12 est propre à recevoir un signal analogique d'entrée.

Le circuit de conversion 14 est adapté à convertir le signal analogique d'entrée en un signal numérique de sortie.

Le circuit de conversion 14 comporte une entrée 14E et une sortie 14S.

L'entrée 14E du circuit de conversion 14 est reliée au récepteur 12 et reçoit le signal analogique d'entrée.

Le signal numérique de sortie est délivré sur la sortie 14S du circuit de conversion 14.

Un tel circuit de conversion 14 comporte un convertisseur analogique-numérique et désigné sous l'acronyme CAN.

En variante, le circuit de conversion 14 comprend aussi une chaîne de traitement analogique, par exemple une chaîne dite de réception. Parmi les composants de la chaîne de traitement analogique, se trouvent, par exemple, un ou plusieurs amplificateurs.

Le correcteur 16 comporte une entrée 16E et une sortie 16S.

L'entrée 16E du correcteur 16 est reliée à la sortie 14S du circuit de conversion 14.

La sortie 16S du correcteur 16 est reliée à l'émetteur 18.

Le correcteur 16 est adapté à générer une fonction de correction.

La fonction de correction est une fonction complexe du signal numérique de sortie. Un signal numérique corrigé est obtenu à partir du signal numérique de sortie et de la fonction de correction.

A titre d'exemple, le correcteur 16 est un circuit logique programmable. Un circuit logique programmable, ou réseau logique programmable, est un circuit intégré logique qui peut être reprogrammé après sa fabrication. Notons qu'il serait impropre de parler de programmation au sens logiciel (contrairement à un microprocesseur, il n'exécute aucune ligne de code). Ici, mieux vaudrait parler de « reconfiguration » plutôt que de reprogrammation (on modifie des connexions ou le comportement du composant, on connecte des portes logiques entre elles, etc.). Le verbe programmer est toutefois le plus fréquent, mais au sens de personnaliser. Il s'agit bel et bien de réseaux logiques reconfigurables et modifiables.

De préférence, le correcteur 16 est un FPGA, acronyme anglais de l'expression *« field-programmable gâte array »*, réseau de portes programmables *in situ.*

*Description d'un premier exemple de mise en oeuvre d'un procédé de correction des défauts d'intermodulation introduits par le circuit de conversion 14*

Le fonctionnement de l'appareil électronique 10 est maintenant décrit en référence à un premier exemple de mise en oeuvre d'un procédé de correction des défauts d'intermodulation introduits par le circuit de conversion 14.

Le procédé de correction comporte une étape a) de fourniture du signal numérique de sortie.

L'étape a) de fourniture du signal numérique de sortie est notamment réalisable par fourniture d'un signal analogique d'entrée sur le récepteur 12 et conversion du signal reçu par le circuit de conversion 14.

Le procédé de correction comprend également une étape b) de génération d'une fonction de correction.

L'étape b) de génération est mise en oeuvre par le correcteur 16.

De manière générale, la fonction de correction est une fonction complexe du signal numérique de sortie.

Selon le premier exemple de mise en oeuvre du procédé de correction, l'étape b) de génération comporte une étape $b1_1$) de calcul d'une première fonction polynômiale du carrée du module du signal numérique de sortie, pour obtenir un premier terme final.

L'étape b) de génération comprend aussi une étape $b2_1$) de calcul d'une deuxième fonction polynômiale du carrée du module du signal numérique de sortie selon une représentation complexe, pour obtenir un deuxième terme intermédiaire.

L'étape b) de génération comporte également une étape $b3_1$) de calcul d'une deuxième fonction polynômiale du carrée du module du signal numérique de sortie selon une représentation complexe, pour obtenir un deuxième terme intermédiaire.

L'étape b) de génération comprend une étape $b4_1$) d'application d'un filtre sur le signal numérique de sortie pour obtenir un signal filtré.

Par exemple, le filtre appliqué à l'étape $b4_1$) d'application restitue la dérivée du signal numérique de sortie c'est-à-dire restitue préférentiellement l'échantillonnage de la dérivée du signal continu avant échantillonnage.

Dans le cas général, par l'expression « restitue l'échantillonnage de la dérivée», il est entendu que le filtre, supposé être réalisable, n'en fournit en fait qu'une approximation et que le filtre ne constitue donc qu'une approximation plus ou moins précise de la fonction idéale interpolation-dérivation-rééchantillonnage du signal numérique de sortie aux instants d'échantillonnage. Dans le cas spécial d'un signal numérique de sortie répétitif, de période multiple de la période d'échantillonnage, le filtre peut alors constituer exactement cette fonction.

Selon le premier exemple, l'étape b) de génération comporte aussi une étape $b5_1$) de calcul du produit du deuxième terme intermédiaire par le produit du complexe conjugué du signal numérique de sortie par le signal filtré, pour obtenir un deuxième terme final.

L'étape b) de génération comporte également une étape $b6_1$) de calcul de la somme du premier terme final et du deuxième terme final, pour obtenir la fonction de correction.

Le procédé de correction comporte aussi une étape c) de correction du signal numérique de sortie pour obtenir un signal numérique de sortie corrigé.

Le signal numérique de sortie corrigé est obtenu à l'aide de la fonction de correction.

Selon un mode de réalisation particulier, le signal numérique de sortie corrigé est égale à la différence entre le signal numérique de sortie et le produit du signal numérique de sortie par la fonction de correction.

Un tel procédé permet donc d'obtenir un signal numérique de sortie dans lequel les défauts d'intermodulation introduits par le circuit de conversion 14 sont réduits. Cela apparaît à la lecture de la section « démonstration mathématique » qui suit.

Autrement formulé, le procédé de correction des défauts d'intermodulation introduits par le circuit de conversion 14 qui permet, avec une mise en oeuvre aisée, de diminuer les défauts d'intermodulation sans générer de la distorsion harmonique non désirée.

Un tel procédé permet d'obtenir un circuit de conversion 14 travaillant à la fois sur porteuse élevée et avec une fréquence d'échantillonnage élevée pour traiter les besoins des bandes les plus larges et présentant des caractéristiques dynamiques excellentes pour satisfaire les besoins en bande étroite à haute résolution.

Cela ouvre la voie à la réalisation pour l'avionique de chaîne de réception unique « partagée » des informations en provenance des nombreux capteurs embarqués sur un avion. En effet, comme expliqué précédemment, lorsque le circuit de conversion 14 est situé en amont de la chaîne de réception, la fonction de conversion réalisée par le circuit de conversion 14 dimensionne la performance de la chaîne. Il convient donc que le circuit de conversion 14 réponde aux besoins différents des radars et des organes de communication de l'avion en termes de dynamique et de largeur de bande. La réalisation de chaîne de réception unique « partagée » des informations permet d'envisager une augmentation des performances du système tout en réduisant l'encombrement, la consommation d'énergie et le coût de l'électronique embarquée. L'invention n'est pas restreinte au seul cas de l'électronique embarquée ou destinée aux seules applications avioniques. L'invention est valable pour toute chaîne de réception et permet d'éliminer les défauts d'intermodulation d'ordres impairs. Il s'agit typiquement des défauts conduisant, pour un ordre d'intermodulation 2N+1 donné, N étant un entier, à la génération de composantes aux fréquences $| m\,f_1 - (m+1)\,f_2 |$ et $| (m+1)\,f_1 - m\,f_2 |$ et avec m positif et inférieur ou égal à l'entier N. L'invention n'a d'intérêt réel que si, par ailleurs, les défauts harmoniques ne se seront pas repliés sur le signal numérique de sortie.

*Description d'un deuxième exemple de mise en oeuvre d'un procédé de correction des défauts d'intermodulation introduits par le circuit de conversion 14*

Selon un deuxième exemple de mise en oeuvre du procédé de contrôle, le procédé de correction comporte également une étape a) de fourniture du signal numérique de sortie.

L'étape a) de fourniture du signal numérique de sortie est identique au premier exemple de mise en oeuvre. Les remarques précédentes s'appliquent donc également à l'étape a) selon le deuxième exemple.

Le procédé de correction comprend également une étape b) de génération de la fonction de correction.

L'étape b) de génération comporte une étape $b1_2$) de filtrage de Hilbert du signal numérique de sortie, pour obtenir un premier signal.

En variante, à l'étape $b1_2$), il est effectué une démodulation numérique du signal numérique de sortie pour obtenir le premier signal.

L'étape b) de génération comporte aussi une étape $b3_2$) d'application d'un premier filtre à phase linéaire sur le premier signal pour obtenir un premier signal filtré.

L'étape b) de génération comporte aussi une étape $b4_2$) de décimation du premier signal filtré pour obtenir un deuxième signal.

En traitement du signal, la décimation est synonyme de sous-échantillonnage : on ne garde qu'un certain nombre d'échantillons par rapport au signal original (un sur 2, un sur 10...).

L'étape b) de génération comporte aussi une étape $b5_2$) d'application d'un deuxième filtre à phase linéaire sur le deuxième signal pour obtenir un deuxième signal filtré.

L'étape b) de génération comporte aussi une étape $b6_2$) de décimation du deuxième signal filtré pour obtenir un troisième signal.

L'étape b) de génération comporte aussi une étape $b7_2$) d'application d'un troisième filtre à phase linéaire sur le troisième signal pour obtenir un troisième signal filtré.

L'étape b) de génération comporte aussi une étape $b8_2$) de décimation du troisième signal filtré pour obtenir un signal de calcul.

En variante, un seul filtre à phase linéaire est appliqué à l'étape b) de génération.

Selon une variante, un nombre de filtre à phase linéaire strictement supérieure à 3 est mis en oeuvre.

Selon une autre variante, aucune étape de décimation n'est utilisée lors de la mise en oeuvre de l'étape b) de génération.

Selon un mode de réalisation particulier, seules certaines étapes d'application d'un filtre à phase linéaire sont suivies d'une étape de décimation.

Le procédé de correction comporte aussi une étape c) de correction du signal numérique de sortie.

Le signal numérique de sortie corrigé est obtenu par application de la fonction de correction au signal de calcul.

Un tel procédé permet donc d'obtenir un signal numérique de sortie dans lequel les défauts d'intermodulation introduits par le circuit de conversion 14 sont réduits. Cela apparaît à la lecture de la section « démonstration mathématique » qui suit.

Autrement formulé, le procédé de correction des défauts d'intermodulation introduits par le circuit de conversion 14 qui permet, avec une mise en oeuvre aisée, de diminuer les défauts d'intermodulation sans générer de la distorsion harmonique non désirée.

*Description d'un troisième exemple de mise en oeuvre d'un procédé de correction des défauts d'intermodulation introduits par le circuit de conversion 14*

Selon un troisième exemple de mise en oeuvre du procédé de contrôle, le procédé de correction comporte également une étape a) de fourniture du signal numérique de sortie.

L'étape a) de fourniture du signal numérique de sortie est identique au premier exemple de mise en oeuvre. Les remarques précédentes s'appliquent donc également à l'étape a) selon le troisième exemple.

Le procédé de correction comprend également une étape b) de génération de la fonction de correction.

L'étape b) de génération comporte une étape $b1_3$) d'application d'un signal de calibration au circuit de conversion 14.

Le signal de calibration est, par exemple, un signal à deux fréquences distinctes.

L'étape b) de génération comporte une étape $b2_3$) de mesure du signal obtenue en sortie du circuit de conversion 14, pour obtenir un signal mesuré.

L'étape b) de génération comporte une étape $b3_3$) d'analyse des composantes spectrales du signal mesuré.

Une telle étape $b3_3$) d'analyse est généralement mise en oeuvre par utilisation d'une transformation de Fourier discrète (TFD) ou d'une transformée de Fourier rapide (FFT). La transformation de Fourier discrète est un outil mathématique de traitement du signal numérique, qui est l'équivalent discret de la transformation de Fourier continue qui est utilisée pour le traitement du signal analogique. La transformation de Fourier rapide (acronyme anglais FFT pour *Fast Fourier Transform*) est un algorithme de calcul de la transformation de Fourier discrète (TFD).

L'étape b) de génération comporte une étape $b3_4$) d'utilisation de la valeur des composantes spectrales du signal mesuré pour en déduire la fonction de correction.

Le procédé de correction comporte aussi une étape c) d'obtention du signal numérique de sortie corrigé.

L'étape c) d'obtention du signal numérique de sortie corrigé est identique au premier exemple de mise en oeuvre. Les remarques précédentes s'appliquent donc également à l'étape c) selon le troisième exemple.

Un tel procédé permet donc d'obtenir un signal numérique de sortie dans lequel les défauts d'intermodulation introduits par le circuit de conversion 14 sont réduits. Cela apparaît à la lecture de la section « démonstration mathématique » qui suit.

Autrement formulé, le procédé de correction des défauts d'intermodulation introduits par le circuit de conversion 14 qui permet, avec une mise en oeuvre aisée, de diminuer les défauts d'intermodulation sans générer de la distorsion harmonique non désirée.

*Autres variantes*

D'autres variantes correspondant à des combinaisons des modes de réalisations précédemment décrits sont également envisageables.

Notamment, il est possible de mettre en oeuvre le procédé avec un système 110 et un produit programme d'ordinateur 112.

Le système 110 et le produit programme d'ordinateur 112 sont représentés à la figure 2. L'interaction du produit programme d'ordinateur 112 avec le système 110 permet de mettre en oeuvre un procédé d'identification d'une relation entre des éléments physiques.

Le système 110 est un ordinateur.

Plus généralement, le système 110 est un calculateur électronique propre à manipuler et/ou transformer des données représentées comme des quantités électroniques ou physiques dans des registres du système 110 et/ou des mémoires en d'autres données similaires correspondant à des données physiques dans des mémoires, des registres ou d'autres types de dispositifs d'affichage, de transmission ou de mémorisation.

Le système 110 comporte un processeur 114 comprenant une unité de traitement de données 116, des mémoires 118 et un lecteur 120 de support d'informations. Le système 110 comprend également un clavier 122 et une unité d'affichage 124.

Le produit programme d'ordinateur 112 comporte un support lisible d'informations 120.

Un support lisible d'informations 120 est un support lisible par le système 110, usuellement par l'unité de traitement de données 114. Le support lisible d'informations 120 est un médium adapté à mémoriser des instructions électroniques et capables d'être couplé à un bus d'un système informatique.

A titre d'exemple, le support lisible d'informations 120 est une disquette ou disque souple (de la dénomination anglaise de « *floppy disk*»), un disque optique, un CD-ROM, un disque magnéto-optique, une mémoire ROM, une mémoire RAM, une mémoire EPROM, une mémoire EEPROM, une carte magnétique ou une carte optique.

Sur le support lisible d'informations 20 est mémorisé un programme d'ordinateur comprenant des instructions de programme.

Le programme d'ordinateur est chargeable sur l'unité de traitement de données 114 et est adapté pour entraîner la mise en oeuvre d'un procédé d'identification d'une relation entre des éléments physiques lorsque le programme d'ordinateur est mis en oeuvre sur l'unité de traitement des données 114.

*Démonstration mathématique*

Comme précisé précédemment, pour traduire les défauts induits par un circuit de conversion 14, il convient de prendre une fonction plus compliquée qu'une simple fonction polynomiale du signal. En effet, la fonction représentation de la distorsion traduit le fait que l'erreur à un instant donné dépend non seulement de la valeur instantanée du signal mais également de ses variations.

En notant s = $\rho e^{j\varphi}$ le signal complexe considéré (c'est-à-dire le signal numérique de sortie) où s est le signal, $\rho$ est le module du signal, j le nombre complexe et le déphasage, alors la dérivée logarithmique du signal s'écrit :

$$\frac{1}{s} \times \frac{\partial s}{\partial t} = \frac{1}{\rho} \times \frac{\partial \rho}{\partial t} + j2\pi \times f_i(t)$$

où $f_i$ est la fréquence instantanée égale à :

$$f_i(t) = \frac{1}{2\pi} \times \frac{\partial \varphi}{\partial t}$$

En négligeant les variations logarithmiques de l'amplitude du signal par rapport aux variations induites par la fréquence instantanée, ce qui est tout à fait justifié dans le cas d'un fonctionnement à bande étroite sur porteuse, alors, si en notant x et y les parties réelle et imaginaire du signal, les relations approchées suivantes sont obtenues :

$$\frac{\partial x}{\partial t} \approx -2\pi \times f_i(t) \times y \quad \text{et} \quad \frac{\partial y}{\partial t} \approx 2\pi \times f_i(t) \times x$$

A l'étude des relations précédentes, il apparaît que les variations de la partie réelle x du signal sont proportionnelles à la partie imaginaire y du signal. Il est donc considéré une traduction mathématique de la distorsion de la partie réelle du signal sous la forme suivante beaucoup plus appropriée :

$$f(x, y) = \alpha_0 \times x^3 + \alpha_1 \times x^2 y + \alpha_2 \times y^2 x + \alpha_3 \times y^3$$

Où :

- $\alpha_0$, $\alpha_1$, $\alpha_2$ et $\alpha_3$ sont des coefficients.

Comme expliqué précédemment, il est proposé d'exploiter la forme précédente particulier de modèles de défaut. D'un point de vue physique, il est possible de montrer que le modèle de défauts donné par la relation ci-dessus se partage en deux parties distinctes et indépendantes : l'intermodulation proche du signal et la distorsion harmonique et l'intermodulation lointaine.

Ainsi qu'expliqué en introduction, il est spécifiquement souhaité se concentrer sur la correction des défauts d'intermodulation puisque les autres défauts sont éliminés grâce au plan de fréquence. Pour cela, il est proposé une reformulation de la relation précédente en fonction d'un seul paramètre noté k(s) qu'il est possible d'acquérir via une phase de calibrage.

Pour un signal s n'étant pas le signal réel issu du circuit de conversion 14 mais un signal complexe obtenu par filtrage de Hilbert, il est considéré le signal suivant :

$$s \rightarrow \left[1 - k(s)\right] \times s$$

Où :

- k(s) est le paramètre et est donné par $k(s) = \alpha \times |s|^2$ avec $\alpha$ un nombre.

Une telle relation permet de corriger les défauts d'intermodulation d'ordre 3.

La fonction k(s)*s correspond dans ce cas à la fonction de correction.

Une telle relation peut s'étendre pour les défauts d'intermodulation d'ordre 5 en modifiant la valeur du paramètre k(s). Dans un tel cas, le paramètre k(s) est donné par la relation suivante :

$$k(s) = \left(\alpha_0 + \alpha_1 |s|^2\right)|s|^2$$

Par généralisation, il s'en suit que pour la correction des défauts d'intermodulation jusqu'à un ordre 2*N+3, N étant un entier positif, le paramètre k(s) est donné par la relation suivante :

$$k(s) = P\left(|s|^2\right) \times |s|^2$$

Où :

- P est un polynôme d'ordre N

Autour d'une fréquence, les coefficients du polynôme peuvent être obtenus à partir d'une phase de calibrage par mesure du niveau des deux tons d'un signal 2-tons et du niveau des parasites d'intermodulation jusqu'à l'ordre 2*N+3.

Pour obtenir une correction dans une bande plus large, il convient de prendre en compte le fait que les coefficients du polynôme P dépendent de la fréquence. Il est possible d'utiliser une dépendance linéaire des coefficients en fonction de la fréquence instantanée. Comme la fréquence instantanée est une fonction du signal complexe, il est abouti à une complexification de la fonction de correction qui comporte alors deux termes faisant chacun intervenir un polynôme :

$$k(s) \times s = \left[P\left(|s|^2\right) + Q\left(|s|^2\right) \times f_i\right] \times |s|^2 \times s = \left[P\left(|s|^2\right) \times |s|^2 + \frac{Q\left(|s|^2\right)}{2\pi} \times \Im\left(s^* \times \left[h_D \otimes s\right]\right)\right] \times s$$

Où :

- Q est un polynôme,
- $\Im$ désigne la fonction mathématique partie imaginaire, et
- $h_D$ désigne la dérivée du filtre interpolateur et a pour réponse aux points d'échantillonnage pour n différent de 0

$$h_D(n) = \frac{(-1)^n}{n}$$ qui peut être approchée sur une durée finie égale à 2*N par $$\widetilde{h}_D(n) = \frac{(-1)^n \pi}{N \times \tan \frac{\pi n}{N}}$$ .

Pour expliciter le procédé de correction, il est possible de décomposer la fonction f(x,y) représentant la distorsion du signal comme la somme de deux termes. Le premier terme s'exprime mathématiquement comme :

$$\begin{aligned} \alpha_0 \times x^3 + \alpha_3 \times y^3 \quad &= \Re\left[\left(\alpha_0 + j \times \alpha_3\right) \times \left(x^3 + \left(j \times y\right)^3\right)\right] \\ &= \Re\left[\left(\alpha_0 + j \times \alpha_3\right) \times \left(x + j \times y\right) \times \left(x^2 - x \times \left(j \times y\right) + \left(j \times y\right)^2\right)\right] \end{aligned}$$

Où :

- $\Re$ désigne la fonction mathématique partie réelle.

Le deuxième terme s'exprime mathématiquement comme :

$$\alpha_1 \times x^2 y + \alpha_2 \times y^2 x = \Re\left[-(\alpha_2 + j \times \alpha_1) \times \left((j \times y)^2 x + x^2 \times j \times y\right)\right]$$
$$= \Re\left[-(\alpha_2 + j \times \alpha_1) \times (x + j \times y) \times x \times (j \times y)\right]$$

En utilisant les deux expressions précédentes du premier terme et du deuxième terme, il en résulte que la fonction f(x,y) représentant la distorsion du signal vaut :

$$f(x,y) = \Re\left[(x + j \times y) \times \left\{(\alpha_0 + j \times \alpha_3) \times \left(x^2 - x \times (j \times y) + (j \times y)^2\right) - (\alpha_2 + j \times \alpha_1) \times x \times (j \times y)\right\}\right]$$
$$= \Re\left[(x + j \times y) \times \left\{\begin{array}{c}(\alpha_0 + j \times \alpha_3) \times \Re\left[(x + (j \times y))^2\right]\\ -\dfrac{(\alpha_2 + j \times \alpha_1) + (\alpha_0 + j \times \alpha_3)}{2} \times j \times \Im\left[(x + (j \times y))^2\right]\end{array}\right\}\right]$$

L'expression précédente se simplifie en posant $z = x + j \times y$ l'extension analytique de x. Il est alors obtenu les expression mathématiques suivantes :

$$f(x,y) = \Re\left[z \times \left\{(\alpha_0 + j \times \alpha_3) \times \frac{z^2 + z^{*2}}{2} - \frac{(\alpha_2 + j \times \alpha_1) + (\alpha_0 + j \times \alpha_3)}{2} \times \frac{z^2 - z^{*2}}{2}\right\}\right]$$
$$= \Re\left[z \times \left\{\frac{(\alpha_0 + j \times \alpha_3) - (\alpha_2 + j \times \alpha_1)}{4} \times z^2 + \frac{3(\alpha_0 + j \times \alpha_3) + (\alpha_2 + j \times \alpha_1)}{4} \times z^{*2}\right\}\right]$$
$$= \Re\left[z \times \left\{\frac{(\alpha_0 + j \times \alpha_3) - (\alpha_2 + j \times \alpha_1)}{4} \times z^2 + \left(\frac{3(\alpha_0 + j \times \alpha_3) + (\alpha_2 + j \times \alpha_1)}{4}\right)^* \times |z|^2\right\}\right]$$

Pour simplifier encore plus l'expression précédente, il est posé :

$$\widetilde{f}(z) = z \times \left\{\frac{(\alpha_0 + j \times \alpha_3) - (\alpha_2 + j \times \alpha_1)}{4} \times z^2 + \left(\frac{3(\alpha_0 + j \times \alpha_3) + (\alpha_2 + j \times \alpha_1)}{4}\right)^* \times |z|^2\right\}$$

L'expression de la fonction f(x,y) représentant la distorsion du signal s'écrit alors :

$$f(x,y) = \frac{\widetilde{f}(z) + \widetilde{f}^*(z)}{2}$$

Or, la correction réelle est la suivante :

$$x = \frac{z + z^*}{2} \rightarrow \frac{z + z^*}{2} - \frac{\widetilde{f}(z) + \widetilde{f}^*(z)}{2}$$

De ce fait, l'expression de la correction du signal complexe s'écrit :

$$\frac{z}{2} \to \frac{z}{2} - \frac{\widetilde{f}(z)}{2} = \frac{z}{2} - \frac{z}{2} \times \left\{ \left[ (\alpha_0 + j \times \alpha_3) - (\alpha_2 + j \times \alpha_1) \right] \times \left( \frac{z}{2} \right)^2 + \left[ 3(\alpha_0 + j \times \alpha_3) + (\alpha_2 + j \times \alpha_1) \right]^* \times \left| \frac{z}{2} \right|^2 \right\}$$

Il est alors possible d'effectuer la correction suivante en complexe sur le signal s = z/2 issu du filtrage de Hilbert :

$$s \to \left[ 1 - k(s) \right] \times s$$

où

$$k(s) = \left[ (\alpha_0 + j \times \alpha_3) - (\alpha_2 + j \times \alpha_1) \right] \times s^2 + \left[ 3(\alpha_0 + j \times \alpha_3) + (\alpha_2 + j \times \alpha_1) \right]^* \times \left| s \right|^2$$

Dans le spectre, les deux termes formant la distorsion s x k(s) ont une signification différente : le premier terme représente le cumul de la distorsion harmonique et de l'intermodulation lointaine alors que le deuxième terme représente l'intermodulation proche. Mathématiquement, cela s'écrit ainsi :

$$s \times k(s) = \underbrace{s \times \left[ (\alpha_0 + j \times \alpha_3) - (\alpha_2 + j \times \alpha_1) \right] \times s^2}_{\substack{\text{distorsion harmonique} \\ + \\ \text{intermodulation lointaine}}} + \underbrace{s \times \left[ 3(\alpha_0 + j \times \alpha_3) + (\alpha_2 + j \times \alpha_1) \right]^* \times \left| s \right|^2}_{\substack{\text{intermodulation} \\ \text{proche porteuse}}}$$

L'opération ainsi décrite s'effectue après passage en complexe. La séparation des termes « lointains » et « proches » permet de réaliser la seule correction des défauts d'intermodulation « proche ». Une telle correction peut s'effectuer après retour du spectre en bande de base puisque la phase introduite transposition n'affecte pas le terme $|s|^2$. Une telle opération peut aussi s'effectuer après filtrage de la distorsion harmonique et décimation sans craindre de générer des produits harmoniques non désirés dont le repliement est à éviter. Cela n'est bien sûr possible qu'à la condition que la bande du signal soit suffisante faible pour que la distorsion harmonique puisse être filtrée par le plan de fréquence ; pour que cela soit possible après filtrage, il convient également que le plan de fréquence ne déforme pas la phase.

Dans le cas où le procédé comporte les étapes du troisième exemple, si deux tons à $f_1$ et $f_2$ sont simultanément présents dans la bande, la fonction f(x,y) représentant la distorsion du signal génère à la fois des parasites harmoniques ($3 f_1$ et $3 f_2$) et des parasites d'intermodulation hors bande (situés à $2 f_1 + f_2$ et $2 f_2 + f_1$) et dans la bande (situés à $2 f_1 - f_2$ et $2 f_2 - f_1$).

Il est alors possible de poser :

$$\begin{cases} x = a_1 \cos \varphi_1 + a_2 \cos \varphi_2 \\ y = a_1 \sin \varphi_1 + a_2 \sin \varphi_2 \end{cases}$$

Il est alors possible d'obtenir en calculant les différents termes impliqués dans la fonction f(x,y) représentant la distorsion du signal :

$$\begin{cases} x^3 = a_1^3 \cos^3 \varphi_1 + a_2^3 \cos^3 \varphi_2 + 3a_1^2 a_2 \cos^2 \varphi_1 \cos \varphi_2 + 3a_2^2 a_1 \cos^2 \varphi_2 \cos \varphi_1 \\ x^2 y = a_1^3 \cos^2 \varphi_1 \sin \varphi_1 + a_2^3 \cos^2 \varphi_2 \sin \varphi_2 \\ \qquad + a_1^2 a_2 \times \left( \cos^2 \varphi_1 \sin \varphi_2 + 2 \sin \varphi_1 \cos \varphi_1 \cos \varphi_2 \right) + a_2^2 a_1 \left( \cos^2 \varphi_2 \sin \varphi_1 + 2 \sin \varphi_2 \cos \varphi_2 \cos \varphi_1 \right) \\ y^2 x = a_1^3 \sin^2 \varphi_1 \cos \varphi_1 + a_2^3 \sin^2 \varphi_2 \cos \varphi_2 \\ \qquad + a_1^2 a_2 \times \left( \sin^2 \varphi_1 \cos \varphi_2 + 2 \cos \varphi_1 \sin \varphi_1 \sin \varphi_2 \right) + a_2^2 a_1 \left( \sin^2 \varphi_2 \cos \varphi_1 + 2 \cos \varphi_2 \sin \varphi_2 \sin \varphi_1 \right) \\ y^3 = a_1^3 \sin^3 \varphi_1 + a_2^3 \sin^3 \varphi_2 + 3a_1^2 a_2 \sin^2 \varphi_1 \sin \varphi_2 + 3a_2^2 a_1 \sin^2 \varphi_2 \sin \varphi_1 \end{cases}$$

Il est alors obtenu une expression pour l'intermodulation et la distorsion harmonique selon laquelle :

$$\begin{cases} x^3 = \dfrac{3a_1^2 a_2}{4}\cos(2\varphi_1 - \varphi_2) + \dfrac{3a_2^2 a_1}{4}\cos(2\varphi_2 - \varphi_1) \\[2mm] \qquad + \dfrac{a_1^3}{4}\cos 3\varphi_1 + \dfrac{a_2^3}{4}\cos 3\varphi_2 + \dfrac{3a_1^2 a_2}{4}\cos(2\varphi_1 + \varphi_2) + \dfrac{3a_2^2 a_1}{4}\cos(2\varphi_2 + \varphi_1) + ... \\[3mm] x^2 y = \dfrac{a_1^2 a_2}{4}\sin(2\varphi_1 - \varphi_2) + \dfrac{a_2^2 a_1}{4}\sin(2\varphi_2 - \varphi_1) \\[2mm] \qquad + \dfrac{a_1^3}{4}\sin 3\varphi_1 + \dfrac{a_2^3}{4}\sin 3\varphi_2 + \dfrac{3a_1^2 a_2}{4}\sin(2\varphi_1 + \varphi_2) + \dfrac{3a_2^2 a_1}{4}\sin(2\varphi_2 + \varphi_1) + ... \\[3mm] y^2 x = \dfrac{a_1^2 a_2}{4}\cos(2\varphi_1 - \varphi_2) + \dfrac{a_2^2 a_1}{4}\cos(2\varphi_2 - \varphi_1) \\[2mm] \qquad - \dfrac{a_1^3}{4}\cos 3\varphi_1 - \dfrac{a_2^3}{4}\cos 3\varphi_2 - \dfrac{3a_1^2 a_2}{4}\cos(2\varphi_1 + \varphi_2) - \dfrac{3a_2^2 a_1}{4}\cos(2\varphi_2 + \varphi_1) + ... \\[3mm] y^3 = \dfrac{3a_1^2 a_2}{4}\sin(2\varphi_1 - \varphi_2) + \dfrac{3a_2^2 a_1}{4}\sin(2\varphi_2 - \varphi_1) \\[2mm] \qquad - \dfrac{a_1^3}{4}\sin 3\varphi_1 - \dfrac{a_2^3}{4}\sin 3\varphi_2 - \dfrac{3a_1^2 a_2}{4}\sin(2\varphi_1 + \varphi_2) - \dfrac{3a_2^2 a_1}{4}\sin(2\varphi_2 + \varphi_1) + ... \end{cases}$$

Les signaux parasites réels induits par le mécanisme de distorsion cubique considéré sur chacune des six fréquences $2f_1 - f_2$, $2f_2 - f_1$, $3f_1$, $2f_1 + f_2$, $2f_2 + f_1$, et $3f_2$ sont alors respectivement les suivants :

$$\begin{cases} \dfrac{a_1^2 a_2}{4}\times\left[(3\alpha_0 + \alpha_2)\times\cos(2\varphi_1 - \varphi_2) + (\alpha_1 + 3\alpha_3)\times\sin(2\varphi_1 - \varphi_2)\right] \\[3mm] \dfrac{a_2^2 a_1}{4}\times\left[(3\alpha_0 + \alpha_2)\times\cos(2\varphi_2 - \varphi_1) + (\alpha_1 + 3\alpha_3)\times\sin(2\varphi_2 - \varphi_1)\right] \\[3mm] \dfrac{a_1^3}{4}\times\left[(\alpha_0 - \alpha_2)\times\cos 3\varphi_1 + (\alpha_1 - \alpha_3)\times\sin 3\varphi_1\right] \\[3mm] \dfrac{3a_1^2 a_2}{4}\times\left[(\alpha_0 - \alpha_2)\times\cos(2\varphi_1 + \varphi_2) + (\alpha_1 - \alpha_3)\times\sin(2\varphi_1 + \varphi_2)\right] \\[3mm] \dfrac{3a_2^2 a_1}{4}\times\left[(\alpha_0 - \alpha_2)\times\cos(2\varphi_2 + \varphi_1) + (\alpha_1 - \alpha_3)\times\sin(2\varphi_2 + \varphi_1)\right] \\[3mm] \dfrac{a_2^3}{4}\left[(\alpha_0 - \alpha_2)\times\cos 3\varphi_2 + (\alpha_1 - \alpha_3)\times\sin 3\varphi_2\right] \end{cases}$$

Lorsque les deux fréquences $f_1$ et $f_2$ sont des fréquences cohérentes sur un pas de transformée de Fourier rapide (aussi désignée par l'acronyme FFT pour « *Fast Fourier Transform* ») correspondant à un nombre de $N_{FFT}$ points ($N_{FFT}$ étant un entier positif), il devient possible de déterminer l'ensemble des grandeurs à partir d'une normalisation de la transformée de Fourier rapide (par $N_{FFT}$) du signal qui permet d'en séparer les différentes contributions spectrales. Pour la suite, il est noté :

- $s_{+1}$ l'amplitude de la composante obtenue à une première fréquence $+f_1$,
- $s_{-1}$ l'amplitude de la composante obtenue à l'opposé de la première fréquence $- f_1$,
- $s_{+2}$ l'amplitude de la composante obtenue à une deuxième fréquence $+f_2$,
- $s_{-2}$ l'amplitude de la composante obtenue à l'opposé de la deuxième fréquence $- f_2$,

- $i_{+12}$ l'amplitude de la composante obtenue à une troisième fréquence +2*$f_1$ - $f_2$,
- $i_{-12}$ l'amplitude de la composante obtenue à l'opposé de la troisième fréquence -2*$f_1$ + $f_2$,
- $i_{+21}$ l'amplitude de la composante obtenue à une quatrième fréquence +2*$f_2$ - $f_1$,
- $i_{-21}$ l'amplitude de la composante obtenue à l'opposé de la quatrième fréquence -2*$f_2$ + $f_1$,
- $h_{+1}$ l'amplitude de la composante obtenue à une cinquième fréquence +3*$f_1$,
- $h_{-1}$ l'amplitude de la composante obtenue à l'opposé de la cinquième fréquence - 3*$f_1$,
- $h_{+12}$ l'amplitude de la composante obtenue à une sixième fréquence +2*$f_1$ + $f_2$,
- $h_{-12}$ l'amplitude de la composante obtenue à l'opposé de la sixième fréquence -2*$f_1$ - $f_2$,
- $h_{+21}$ l'amplitude de la composante obtenue à une septième fréquence +2$f_2$ + $f_1$,
- $h_{-21}$ l'amplitude de la composante obtenue à l'opposé de la septième fréquence -2$f_2$ - $f_1$,
- $h_{+2}$ l'amplitude de la composante obtenue à une huitième fréquence +3*$f_2$, et
- $h_{-2}$ l'amplitude de la composante obtenue à l'opposé de la huitième fréquence - 3*$f_2$.

Pour chacune des notations introduites, il est à noter que, comme les signaux sont réels, chacune des amplitudes notées avec un indice négatif, c'est-à-dire les grandeurs négatives que sont $s_{-1}$, $i_{-12}$, $i_{-21}$, $h_{-1}$, $h_{-12}$, $h_{-21}$ et $h_{-2}$, sont les conjuguées des amplitudes correspondantes notées avec un indice positif, c'est-à-dire les grandeurs positives que sont $s_{+1}$, $i_{+12}$, $i_{+21}$, $h_{+1}$, $h_{+12}$, $h_{+21}$ et $h_{+2}$.

Or, il est connu que $\sin \varphi = \Re\left(- j \times e^{j\varphi}\right)$, il est alors obtenu pour l'amplitude de la composante obtenue à la première fréquence +$f_1$ et l'amplitude de la composante obtenue à la deuxième fréquence +$f_2$ les relations suivantes :

$$\begin{cases} s_{+1} = a_1 e^{j\varphi_1} \big/ 2 \\ s_{+2} = a_2 e^{j\varphi_2} \big/ 2 \end{cases}$$

Similairement, la relation $\sin \varphi = \Re\left(- j \times e^{j\varphi}\right)$ permet d'obtenir pour l'amplitude de la composante obtenue à la troisième fréquence +2*$f_1$ - $f_2$ et l'amplitude de la composante obtenue à une quatrième fréquence +2*$f_2$ - $f_1$ les relations suivantes :

$$\begin{cases} i_{+12} = \dfrac{a_1^2 a_2}{8} \times \left[(3\alpha_0 + \alpha_2) - j \times (\alpha_1 + 3\alpha_3)\right] \times e^{j(2\varphi_1 - \varphi_2)} = \left[(3\alpha_0 + \alpha_2) - j \times (\alpha_1 + 3\alpha_3)\right] \times s_1^2 s_2^* \\ i_{+21} = \dfrac{a_2^2 a_1}{8} \times \left[(3\alpha_0 + \alpha_2) - j \times (\alpha_1 + 3\alpha_3)\right] \times e^{j(2\varphi_2 - \varphi_1)} = \left[(3\alpha_0 + \alpha_2) - j \times (\alpha_1 + 3\alpha_3)\right] \times s_2^2 s_1^* \end{cases}$$

où la notation « * » en exposant renvoie à l'opération mathématique de conjugaison.

Similairement, la relation $\sin \varphi = \Re\left(- j \times e^{j\varphi}\right)$ permet d'obtenir des relations pour l'amplitude de la composante obtenue à la cinquième fréquence +3*$f_1$, l'amplitude de la composante obtenue à la sixième fréquence +2*$f_1$ + $f_2$, l'amplitude de la composante obtenue à la septième fréquence +2$f_2$ + $f_1$ et l'amplitude de la composante obtenue à la huitième fréquence +3*$f_2$. Le système suivant donne le détail de chacune des relations mathématiques précédentes :

$$\begin{cases} h_{+1} = \dfrac{a_1^3}{8} \times \left[ (\alpha_0 - \alpha_2) - j \times (\alpha_1 - \alpha_3) \right] \times e^{j3\varphi_1} = \left[ (\alpha_0 - \alpha_2) - j \times (\alpha_1 - \alpha_3) \right] \times s_1^3 \\[2mm] h_{+12} = \dfrac{3a_1^2 a_2}{8} \times \left[ (\alpha_0 - \alpha_2) - j(\alpha_1 - \alpha_3) \right] \times e^{j(2\varphi_1 + \varphi_2)} = \left[ (\alpha_0 - \alpha_2) - j(\alpha_1 - \alpha_3) \right] \times 3s_1^2 s_2 \\[2mm] h_{+21} = \dfrac{3a_2^2 a_1}{8} \times \left[ (\alpha_0 - \alpha_2) - j(\alpha_1 - \alpha_3) \right] \times e^{j(2\varphi_2 + \varphi_1)} = \left[ (\alpha_0 - \alpha_2) - j(\alpha_1 - \alpha_3) \right] \times 3s_2^2 s_1 \\[2mm] h_{+2} = \dfrac{a_2^3}{8} \times \left[ (\alpha_0 - \alpha_2) - j \times (\alpha_1 - \alpha_3) \right] \times e^{j3\varphi_2} = \left[ (\alpha_0 - \alpha_2) - j \times (\alpha_1 - \alpha_3) \right] \times s_2^3 \end{cases}$$

Par identification des différents termes, il est obtenu le système d'équations suivant :

$$\left[ 3(\alpha_0 + j \times \alpha_3) + (\alpha_2 + j \times \alpha_1) \right]^* = \begin{cases} \dfrac{i_{+12}}{s_1^2 s_2^*} \\[3mm] \dfrac{i_{+21}}{s_2^2 s_1^*} \end{cases} \qquad (\alpha_0 + j \times \alpha_3) - (\alpha_2 + j \times \alpha_1) = \begin{cases} \dfrac{h_{+1}}{s_1^3} \\[3mm] \dfrac{h_{+12}}{3s_1^2 s_2} \\[3mm] \dfrac{h_{+21}}{3s_2^2 s_1} \\[3mm] \dfrac{h_{+2}}{s_2^3} \end{cases}$$

A l'analyse du système d'équations obtenu, il apparaît qu'il s'agit d'un système d'équations avec une forte redondance. Dès lors, il est possible de considérer un système d'équations dit « moyen » en utilisant des opérations de moyennages, notamment par emploi de moyenne arithmétique.

Selon un premier exemple, il est obtenu le système d'équations dit « moyen » suivant :

$$\begin{cases} \left[ 3(\alpha_0 + j \times \alpha_3) + (\alpha_2 + j \times \alpha_1) \right]^* = \dfrac{1}{|s_1 s_2|} \left( \dfrac{i_{+12} i_{+21}}{s_1 s_2} \right)^{1/2} \\[4mm] (\alpha_0 + j \times \alpha_3) - (\alpha_2 + j \times \alpha_1) = \dfrac{1}{s_1 s_2} \left( \dfrac{h_{+1} h_{+12} h_{+21} h_{+2}}{9 s_1^2 s_2^2} \right)^{1/4} \end{cases}$$

Selon un deuxième exemple, il est obtenu le système d'équations dit « moyen » suivant :

$$\begin{cases} \left[ 3(\alpha_0 + j \times \alpha_3) + (\alpha_2 + j \times \alpha_1) \right]^* = \dfrac{1}{2} \left( \dfrac{i_{+12}}{s_1^2 s_2^*} + \dfrac{i_{+21}}{s_2^2 s_1^*} \right) \\[4mm] (\alpha_0 + j \times \alpha_3) - (\alpha_2 + j \times \alpha_1) = \dfrac{1}{4} \left( \dfrac{h_{+1}}{s_1^3} + \dfrac{h_{+12}}{3 s_1^2 s_2} + \dfrac{h_{+21}}{3 s_2^2 s_1} + \dfrac{h_{+2}}{s_2^3} \right) \end{cases}$$

Le procédé de correction précédemment décrit s'applique également pour corriger des intermodulations d'ordre différent.

Une telle extension s'obtient en utilisant des polynômes d'ordres supérieurs en $|s|^2$, c'est-à-dire des termes de correction de la forme $k(s) \times s = |s|^2 \times P(|s|^2) \times s$.

En supposant que $s = s_1 + s_2$ où $s_1$ et $s_2$ sont deux signaux aux fréquences $f_1$ et $f_2$, il est alors obtenu l'expression mathématique suivante:

$$|s|^2 = |s_1 + s_2|^2 = \left(|s_1|^2 + |s_2|^2\right) + \left(s_1^* s_2 + s_2^* s_1\right)$$

Il en résulte que :

$$|s|^{2n} = \left[\left(|s_1|^2 + |s_2|^2\right) + \left(s_1^* s_2 + s_2^* s_1\right)\right]^n = \sum_{k=0}^{n} C_n^k \left(|s_1|^2 + |s_2|^2\right)^{n-k} \left(s_1^* s_2 + s_2^* s_1\right)^k$$

où les coefficients $C_n^k$ sont les coefficients du binôme.

Or, en écrivant le premier signal $s_1$ et le deuxième signal $s_2$ sous forme complexe, c'est-à-dire, si $s_1 = |s_1| \times e^{j\varphi_1}$ et $s_2 = |s_2| \times e^{j\varphi_2}$, la relation précédente s'écrit:

$$
\begin{aligned}
|s|^{2n} &= \sum_{k=0}^{n} C_n^k \left(|s_1|^2 + |s_2|^2\right)^{n-k} \sum_{q=0}^{k} C_k^q s_1^{*q} s_2^q s_2^{*(k-q)} s_1^{k-q} \\
&= \sum_{k=0}^{n} C_n^k \left(|s_1|^2 + |s_2|^2\right)^{n-k} |s_1|^k |s_2|^k \sum_{q=0}^{k} C_k^q e^{j(k-2q)(\varphi_1 - \varphi_2)}
\end{aligned}
$$

D'où il résulte que :

$$|s|^{2n} \times s = \left(|s_1| e^{\varphi_1} + |s_2| e^{\varphi_2}\right) \times \sum_{k=0}^{n} C_n^k \left(|s_1|^2 + |s_2|^2\right)^{n-k} |s_1|^k |s_2|^k \sum_{q=0}^{k} C_k^q e^{j(k-2q)(\varphi_1 - \varphi_2)}$$

Une telle formule s'applique notamment pour l'intermodulation d'ordre 5. Dans un tel cas, l'entier n est égal à 2. Ceci s'écrit mathématiquement comme :

$$|s|^4 \times s = \left(|s_1| e^{\varphi_1} + |s_2| e^{\varphi_2}\right) \times \sum_{k=0}^{2} C_2^k \left(|s_1|^2 + |s_2|^2\right)^{2-k} |s_1|^k |s_2|^k \sum_{q=0}^{k} C_k^q e^{j(k-2q)(\varphi_1 - \varphi_2)}$$

De manière plus explicite, l'expression précédente s'écrit :

$$
\begin{aligned}
|s|^4 \times s = \ldots &+ |s_1|^2 \times |s_2|^2 \times \left(|s_1| e^{j(3\varphi_1 - 2\varphi_2)} + |s_2| e^{j(3\varphi_2 - 2\varphi_1)}\right) \\
&+ \left(2|s_1|^2 + 3|s_2|^2\right) \times |s_1|^2 \times |s_2| e^{j(2\varphi_1 - \varphi_2)} + \left(2|s_2|^2 + 3|s_1|^2\right) \times |s_2|^2 \times |s_1| e^{j(2\varphi_2 - \varphi_1)}
\end{aligned}
$$

Or, il est rappelé que dans ce cas, nous avons $P(|s|^2) \times |s|^2 \times s = (\alpha^{(0)} + \alpha^{(1)}|s|^2) \times |s|^2 \times s$, d'où il est déduit que :

$$
\begin{aligned}
|s|^4 \times s = \ldots &+ \alpha^{(1)} \times |s_1|^2 \times |s_2|^2 \times \left(|s_1| e^{j(3\varphi_1 - 2\varphi_2)} + |s_2| e^{j(3\varphi_2 - 2\varphi_1)}\right) \\
&+ \left[\alpha^{(0)} + \alpha^{(1)} \times \left(2|s_1|^2 + 3|s_2|^2\right)\right] \times |s_1|^2 \times |s_2| \times e^{j(2\varphi_1 - \varphi_2)} \\
&+ \left[\alpha^{(0)} + \alpha^{(1)} \times \left(2|s_2|^2 + 3|s_1|^2\right)\right] \times |s_2|^2 \times |s_1| \times e^{j(2\varphi_2 - \varphi_1)}
\end{aligned}
$$

Ainsi, il est obtenu le résultat suivant :

$$|s|^4 \times s = \dots + \underbrace{\alpha^{(1)} \times s_1^3 s_2^{*2}}_{i_{12}^{(5)}} + \underbrace{\alpha^{(1)} \times s_2^3 s_1^{*2}}_{i_{21}^{(5)}} + \underbrace{\left[\alpha^{(0)} + \alpha^{(1)} \times \left(2|s_1|^2 + 3|s_2|^2\right)\right] \times s_1^2 s_2^*}_{i_{12}^{(3)}}$$

$$+ \underbrace{\left[\alpha^{(0)} + \alpha^{(1)} \times \left(2|s_2|^2 + 3|s_1|^2\right)\right] \times s_2^2 s_1^*}_{i_{21}^{(3)}}$$

Ainsi, à partir des mesures d'intermodulation, il est obtenu en notant respectivement $i_{12}^{(2p+1)}$ et $i_{21}^{(2p+1)}$ les produits d'intermodulation à $(p+1) \times f_1 + p \times f_2$ et $(p+1) \times f_2 + p \times f_1$ le système d'équations suivant:

$$\begin{cases} \alpha^{(0)} + \alpha^{(1)} \times \left(2|s_1|^2 + 3|s_2|^2\right) = \dfrac{i_{12}^{(3)}}{s_1^2 s_2^*} \\[2ex] \alpha^{(0)} + \alpha^{(1)} \times \left(2|s_2|^2 + 3|s_1|^2\right) = \dfrac{i_{21}^{(3)}}{s_2^2 s_1^*} \end{cases} \text{et} \begin{cases} \alpha^{(1)} = \dfrac{i_{12}^{(5)}}{s_1^3 s_2^{*2}} \\[2ex] \alpha^{(1)} = \dfrac{i_{21}^{(5)}}{s_2^3 s_1^{*2}} \end{cases}$$

Il est possible de démontrer qu'un tel système redondant a une solution et qu'il est favorable de considérer une solution moyenne comme la solution qui suit, à savoir :

$$\alpha^{(1)} = \frac{1}{2}\left(\frac{i_{12}^{(5)}}{s_1^3 s_2^{*2}} + \frac{i_{21}^{(5)}}{s_2^3 s_1^{*2}}\right) \text{ et } \alpha^{(0)} = \frac{1}{2}\left(\frac{i_{12}^{(3)}}{s_1^2 s_2^*} + \frac{i_{21}^{(3)}}{s_2^2 s_1^*}\right) - \frac{5}{2}\left(|s_1|^2 + |s_2|^2\right) \times \alpha^{(1)}$$

Ceci prouve qu'il est possible de corriger l'intermodulation d'ordre 5.

$$|s|^{2n} \times s = \left(|s_1|e^{\varphi_1} + |s_2|e^{\varphi_2}\right) \times \sum_{k=0}^{n} C_n^k \left(|s_1|^2 + |s_2|^2\right)^{n-k} |s_1|^k |s_2|^k \sum_{q=0}^{k} C_k^q e^{j(k-2q)(\varphi_1-\varphi_2)}$$

La formule                                                                                                                            s'applique également pour l'intermodulation d'ordre 7. Dans un tel cas, l'entier n est égal à 3. Ceci s'écrit mathématiquement comme :

$$|s|^6 \times s = \left(|s_1|e^{\varphi_1} + |s_2|e^{\varphi_2}\right) \times \begin{pmatrix} \dots \\[2ex] + C_3^1 \times \left(|s_1|^2 + |s_2|^2\right)^2 \times |s_1| \times |s_2| \times \sum_{q=0}^{1} C_1^q e^{j(1-2q)(\varphi_1-\varphi_2)} \\[2ex] + C_3^2 \times \left(|s_1|^2 + |s_2|^2\right) \times |s_1|^2 \times |s_2|^2 \times \sum_{q=0}^{2} C_2^q e^{j(2-2q)(\varphi_1-\varphi_2)} \\[2ex] + C_3^3 \times |s_1|^3 \times |s_2|^3 \times \sum_{q=0}^{3} C_3^q e^{j(3-2q)(\varphi_1-\varphi_2)} \end{pmatrix}$$

De manière plus explicite, l'expression précédente s'écrit :

$$|s|^6 \times s = \left(|s_1|e^{\varphi_1} + |s_2|e^{\varphi_2}\right) \times \begin{pmatrix} \dots \\[2ex] + 3 \times \left(|s_1|^2 + |s_2|^2\right)^2 \times |s_1| \times |s_2| \times \left(e^{j(\varphi_1-\varphi_2)} + e^{-j(\varphi_1-\varphi_2)}\right) \\[2ex] + 3 \times \left(|s_1|^2 + |s_2|^2\right) \times |s_1|^2 \times |s_2|^2 \times \left(e^{2j(\varphi_1-\varphi_2)} + 2 + e^{-2j(\varphi_1-\varphi_2)}\right) \\[2ex] + |s_1|^3 \times |s_2|^3 \times \left(e^{3j(\varphi_1-\varphi_2)} + 3e^{j(\varphi_1-\varphi_2)} + 3e^{-j(\varphi_1-\varphi_2)} + e^{3j(\varphi_1-\varphi_2)}\right) \end{pmatrix}$$

Il est ainsi obtenu l'expression qui suit :

$$|s|^6 \times s = \dots$$
$$+ 3 \times \left( |s_1|^4 + 4|s_1|^2 \times |s_2|^2 + 2|s_2|^4 \right) \times |s_1|^2 \times |s_2| \times e^{j(2\varphi_1 - \varphi_2)}$$
$$+ 3 \times \left( |s_2|^4 + 4|s_2|^2 \times |s_1|^2 + 2|s_1|^4 \right) \times |s_2|^2 \times |s_1| \times e^{j(2\varphi_2 - \varphi_1)}$$
$$+ \left( 3|s_1|^2 + 4|s_2|^2 \right) \times |s_1|^3 \times |s_2|^2 \times e^{j(3\varphi_1 - 2\varphi_2)} + \left( 3|s_2|^2 + 4|s_1|^2 \right) \times |s_2|^3 \times |s_1|^2 \times e^{j(3\varphi_2 - 2\varphi_1)}$$
$$+ |s_1|^4 \times |s_2|^3 \times e^{j(4\varphi_1 - 3\varphi_2)} + |s_1|^3 \times |s_2|^4 \times e^{j(4\varphi_2 - 3\varphi_1)}$$

C'est-à-dire :

$$|s|^6 \times s = \dots + s_1^4 s_2^{*3} + s_2^4 s_1^{*3} + \left( 3|s_1|^2 + 4|s_2|^2 \right) \times s_1^3 s_2^{*2} + \left( 3|s_2|^2 + 4|s_1|^2 \right) \times s_2^3 s_1^{*2}$$
$$+ 3 \times \left( |s_1|^4 + 4|s_1|^2 \times |s_2|^2 + 2|s_2|^4 \right) \times s_1^2 s_2^* + 3 \times \left( |s_2|^4 + 4|s_2|^2 \times |s_1|^2 + 2|s_1|^4 \right) \times s_2^2 s_1^*$$

Or, il est rappelé que dans ce cas, nous avons $P(|s|^2) \times |s|^2 \times s = (\alpha^{(0)} + \alpha^{(1)}|s|^2 + \alpha^{(2)}|s|^4) \times |s|^2 \times s$, d'où il est déduit que :

$$|s|^6 \times s = \dots + \underbrace{\alpha^{(2)} \times s_1^4 s_2^{*3}}_{i_{12}^{(7)}} + \underbrace{\alpha^{(2)} \times s_2^4 s_1^{*3}}_{i_{21}^{(7)}}$$
$$+ \underbrace{\left[ \alpha^{(1)} + \alpha^{(2)} \times \left( 3|s_1|^2 + 4|s_2|^2 \right) \right] \times s_1^3 s_2^{*2}}_{i_{12}^{(5)}} + \underbrace{\left[ \alpha^{(1)} + \alpha^{(2)} \times \left( 3|s_2|^2 + 4|s_1|^2 \right) \right] \times s_2^3 s_1^{*2}}_{i_{21}^{(5)}}$$
$$+ \underbrace{\left[ \alpha^{(0)} + \alpha^{(1)} \times \left( 2|s_1|^2 + 3|s_2|^2 \right) + 3\alpha^{(2)} \times \left( |s_1|^4 + 4|s_1|^2 \times |s_2|^2 + 2|s_2|^4 \right) \right] \times s_1^2 s_2^*}_{i_{12}^{(3)}}$$
$$+ \underbrace{\left[ \alpha^{(0)} + \alpha^{(1)} \times \left( 2|s_2|^2 + 3|s_1|^2 \right) + 3\alpha^{(2)} \times \left( |s_2|^4 + 4|s_2|^2 \times |s_1|^2 + 2|s_1|^4 \right) \right] \times s_2^2 s_1^*}_{i_{21}^{(3)}}$$

Ainsi, à partir des mesures d'intermodulation, il est obtenu en notant respectivement $i_{12}^{(2p+1)}$ et $i_{21}^{(2p+1)}$ les produits d'intermodulation à $(p+1) \times f_1 + p \times f_2$ et $(p+1) \times f_2 + p \times f_1$ le système d'équations suivant:

$$\begin{cases} \alpha^{(2)} = \dfrac{i_{12}^{(7)}}{s_1^4 s_2^{*3}} \\[2mm] \alpha^{(2)} = \dfrac{i_{21}^{(7)}}{s_2^4 s_1^{*3}} \end{cases} \text{ainsi que} \quad \begin{cases} \alpha^{(1)} + \alpha^{(2)} \times \left( 3|s_1|^2 + 4|s_2|^2 \right) = \dfrac{i_{12}^{(5)}}{s_1^3 s_2^{*2}} \\[2mm] \alpha^{(1)} + \alpha^{(2)} \times \left( 3|s_2|^2 + 4|s_1|^2 \right) = \dfrac{i_{21}^{(5)}}{s_2^3 s_1^{*2}} \end{cases}$$

et :

$$\begin{cases} \alpha^{(0)} + \alpha^{(1)} \times \left(2|s_1|^2 + 3|s_2|^2\right) + 3\alpha^{(2)} \times \left(|s_1|^4 + 4|s_1|^2 \times |s_2|^2 + 2|s_2|^4\right) = \dfrac{i_{12}^{(3)}}{s_1^2 s_2^*} \\[4mm] \alpha^{(0)} + \alpha^{(1)} \times \left(2|s_2|^2 + 3|s_1|^2\right) + 3\alpha^{(2)} \times \left(|s_2|^4 + 4|s_2|^2 \times |s_1|^2 + 2|s_1|^4\right) = \dfrac{i_{21}^{(3)}}{s_2^2 s_1^*} \end{cases}$$

Il est possible de démontrer qu'un tel système redondant a une solution et qu'il est favorable de considérer une solution moyenne comme la solution qui suit, à savoir :

•

$$\alpha^{(2)} = \frac{1}{2}\left(\frac{i_{12}^{(7)}}{s_1^4 s_2^{*3}} + \frac{i_{21}^{(7)}}{s_2^4 s_1^{*3}}\right),$$

•

$$\alpha^{(1)} = \frac{1}{2}\left(\frac{i_{12}^{(5)}}{s_1^3 s_2^{*2}} + \frac{i_{21}^{(5)}}{s_2^3 s_1^{*2}}\right) - \frac{7}{2}\left(|s_1|^2 + |s_2|^2\right) \times \alpha^{(2)}$$

et

•

$$\alpha^{(0)} = \frac{1}{2}\left(\frac{i_{12}^{(3)}}{s_1^2 s_2^*} + \frac{i_{21}^{(3)}}{s_2^2 s_1^*}\right) - \frac{5}{2} \times \left(|s_1|^2 + |s_2|^2\right) \times \alpha^{(1)} - \frac{3}{2} \times \left(3|s_1|^4 + 8|s_1|^2 \times |s_2|^2 + 3|s_2|^4\right) \times \alpha^{(2)}$$

Ceci prouve qu'il est possible de corriger l'intermodulation d'ordre 7.

Il est possible de démontrer que la démarche suivie pour l'intermodulation d'ordre 5 et l'intermodulation d'ordre 7 s'applique aussi pour des intermodulations d'ordres supérieurs.

La prise en compte de termes jusqu'à l'ordre 2n+1 s'effectue de façon similaire ; elle est laborieuse mais ne comporte pas de difficulté de principe. Comme pour n = 1, 2 ou 3 on obtient un système triangulaire qui permet de calculer $\alpha^{(n-1)}$ en premier puis successivement $\alpha^{(n-2)}$, $\alpha^{(n-3)}$, ... , jusqu'à $\alpha^{(0)}$.

Dans ce qui suit, il est étudié la dépendance par rapport à la fréquence instantanée.

Comme expliqué précédemment, la correction à retrancher au signal s'écrit sous la forme mathématique suivante :

$$k(s) \times s = P\!\left(|s|^2\right) \times |s|^2 \times s$$

Ce résultat, obtenu sous l'hypothèse que la bande instantanée est faible, peut être conservé dans sa forme dans une bande plus large sous la condition que les coefficients du polynôme P dépendent de la fréquence instantanée. Pour cela, il est considéré une dépendance linéaire :

$$k(s) \times s = \left[P\!\left(|s|^2\right) + Q\!\left(|s|^2\right) \times f_i\right] \times |s|^2 \times s$$

Or la fréquence instantanée est, à un facteur multiplicatif $2\pi$ près, égale à la partie imaginaire de la dérivée logarithmique du signal :

$$f_i = \frac{1}{2\pi}\Im\!\left(\frac{s'}{s}\right) = \frac{1}{2\pi} \times \frac{\Im\!\left(s' \times s^*\right)}{|s|^2}$$

Ainsi, l'équation relative au produit $k(s) \times s$ s'écrit mathématiquement comme :

$$k(s) \times s = \left[ P\left(|s|^2\right) + Q\left(|s|^2\right) \times f_i \right] \times |s|^2 \times s = \left[ P\left(|s|^2\right) \times |s|^2 + \frac{Q\left(|s|^2\right)}{2\pi} \times \Im\left(s^* \times s'\right) \right] \times s$$

Dans la relation précédente, supposée être calculée dans le domaine du temps discret (c'est-à-dire sur signal échantillonné), s' représente les valeurs de la dérivée du signal complexe aux instants d'échantillonnage. Il s'agit donc du filtrage du signal s par le filtre dérivateur, qui correspond en fait à l'échantillonnage de la dérivée du filtre interpolateur de réponse temporelle en un sinus cardinal. De ce fait, la relation précédente s'exprime comme :

$$k(s) \times s = \left[ \alpha \times |s|^2 + \beta \times \Im\left(s^* \times s'\right) \right] \times s = \left[ \alpha \times |s|^2 + \beta \times \Im\left(s^* \times \left[h_D \otimes s\right]\right) \right] \times s$$

Où :

- $$\beta = \frac{Q\left(|s|^2\right)}{2\pi},$$

- $$h_D(n) = \frac{(-1)^n}{n}$$ du fait que la réponse du filtre interpolateur est $$h_I(t) = \frac{\sin(\pi f_{ECH} t)}{\pi f_{ECH} t}$$. Il s'en déduit que la dérivée du filtre interpolateur est $$h_I'(t) = \frac{\pi f_{ECH} t \times \cos(\pi f_{ECH} t) - \sin(\pi f_{ECH} t)}{\pi f_{ECH} t^2}$$ dont les valeurs aux points

$$h_D(n) = \frac{\partial h_I}{\partial (f_{ECH} t)}\left(n / f_{ECH}\right) = \frac{1}{f_{ECH}} \times \frac{(-1)^n}{n} f_{ECH}$$

d'échantillonnage sont pour n différent de 0 données par

soit $$h_D(n) = \frac{(-1)^n}{n}$$

Il est à remarquer que la forme de k(s) (déterminée par le terme entre [ ]) ne dépend pas de la fréquence instantanée $f_i$. Cela signifie que la forme de k(s) est indépendante de la position dans la chaîne de démodulation.

Par contre, la valeur des coefficients des polynômes P et Q dépendent de la fréquence instantanée $f_i$ de la porteuse du signal, la démodulation par une fréquence $f_{OL}$ revenant à transférer le terme $Q(|s|^2) \times f_{OL}$ sur $P(|s|^2)$. Bien entendu, le filtre $h_D$, qui ne dépend pas du signal, ne dépend pas de la valeur de la fréquence instantanée $f_i$.

Il est donc constaté que, malgré la dépendance par rapport à la fréquence instantanée, la forme de la correction reste invariante dans la transposition du spectre (même si les coefficients varient) si bien qu'il reste possible d'effectuer la correction après retour en bande de base et décimation, ce qui facilite grandement les opérations.

Par exemple, la connaissance des coefficients des deux polynômes P et Q s'obtient par calibrage. Pour cela, il convient d'effectuer deux mesures de calibrage sur deux fréquences instantanées différentes $f_1$ et $f_2$. Pour les deux mesures, il est obtenu par la méthode précédente deux polynômes $P_1$ et $P_2$ a priori différents :

$$\begin{cases} P_1 = P + Q \times f_1 \\ P_2 = P + Q \times f_2 \end{cases}$$

ce qui permet d'obtenir les valeurs de $\alpha$ et de $\beta$ en utilisant le système :

$$\begin{cases} P = \dfrac{P_2 f_2 - P_1 f_1}{f_2 - f_1} \\[2mm] Q = \dfrac{P_2 - P_1}{f_2 - f_1} \end{cases}$$

Pour un couple de fréquences $f_A$ et $f_B$ donné, il est obtenu :

$$\begin{cases} x = a_A \cos \varphi_A + a_B \cos \varphi_B \\ y = a_A \sin \varphi_A + a_B \sin \varphi_B \end{cases} \text{avec} \begin{cases} \varphi_A = 2\pi f_A t \\ \varphi_B = 2\pi f_B t \end{cases}$$

Il en résulte alors que la fréquence instantanée vaut :

$$f_i = \frac{\Im\left(s^* \times s'\right)}{2\pi |s|^2}$$

$$= \frac{\left(a_A \cos \varphi_A + a_B \cos \varphi_B\right)\left(a_A f_A \cos \varphi_A + a_B f_B \cos \varphi_B\right) + \left(a_A \sin \varphi_A + a_B \sin \varphi_B\right)\left(a_A f_A \sin \varphi_A + a_B f_B \sin \varphi_B\right)}{\left(a_A \cos \varphi_A + a_B \cos \varphi_B\right)^2 + \left(a_A \sin \varphi_A + a_B \sin \varphi_B\right)^2}$$

C'est-à-dire :

$$f_i = \frac{a_A^2 f_A + a_B^2 f_B + a_A a_B \left(f_A + f_B\right)\cos\left(\varphi_A - \varphi_B\right)}{a_A^2 + a_B^2 + 2 a_A a_B \cos\left(\varphi_A - \varphi_B\right)}$$

Comme la fréquence instantanée $f_i$ varie avec le temps, il est considéré la valeur moyenne de la fréquence instantanée $f_i$ pondérée par la puissance du signal pour favoriser les instants où le signal présente l'amplitude la plus grande. En remarquant que la valeur moyenne de $\cos(\varphi_A - \varphi_B)$ est nulle étant donné que, par hypothèse, la fréquence $f_A$ est différente de la fréquence $f_B$, il est obtenu la formule suivante pour la valeur moyenne de la fréquence instantanée $f_i$, valeur moyenne notée $< f_i >$:

$$\langle f_i \rangle = \frac{\displaystyle\int_0^{2\pi} \frac{a_A^2 f_A + a_B^2 f_B + a_A a_B \left(f_A + f_B\right)\cos\left(\varphi_A - \varphi_B\right)}{a_A^2 + a_B^2 + 2 a_A a_B \cos \varphi} \times \left(a_A^2 + a_B^2 + 2 a_A a_B \cos \varphi\right) d\varphi}{\displaystyle\int_0^{2\pi} \left(a_A^2 + a_B^2 + 2 a_A a_B \cos \varphi\right) d\varphi} = \frac{a_A^2 f_A + a_B^2 f_B}{a_A^2 + a_B^2}$$

Dans le cas où l'amplitude des deux signaux à la fréquence $f_A$ et à la fréquence $f_B$ sont les mêmes, on a alors $a_A = a_B$, ce qui résulte en $< f_i > = (f_A + f_B) / 2$.

Les amplitudes de chacune des composante peuvent être calculés par transformée de Fourier rapide ou, compte tenu du faible nombre de points à calculer, par simple transformation de Fourier discrète.

Pour des questions de simplicité, il est généré des fréquences sur un pas de transformée de Fourier rapide le plus large possible. Le nombre de points dépend de l'ordre maximum à corriger. Pour une correction jusqu'à l'ordre $2*N+1$, le nombre total $n_{FFT}$ de composantes à mesurer est de $2*(N+1)$. Il est souhaitable que les fréquences des deux calibrages soient le plus éloignées l'une de l'autre tout en conservant un nombre minimum de points de transformée de Fourier rapide. Le cas extrême consiste à prendre :

- $n_{FFT} = 2(N+1)$ d'une part, et
- $f_A = \pm f_{ECH}/2$ et $f_B = \pm N/(N+1) \times f_{ECH}/2$ d'autre part

En variante, il est également possible de rapprocher les fréquences pour être moins sensible à la réponse du filtre de décimation qui atténue inévitablement les bords de la bande d'échantillonnage. Ainsi, lorsque seuls les termes d'ordre 3 sont à corriger, il est possible de considérer une transformée de Fourier rapide à 4 points dont le calcul est extrêmement simple avec $f_A = \pm f_{ECH}/4$ et $f_B = 0$. Dans ce cas les produits d'intermodulation sont situés à $\pm f_{ECH}/2$ et $-f_A$.

*Simulations*

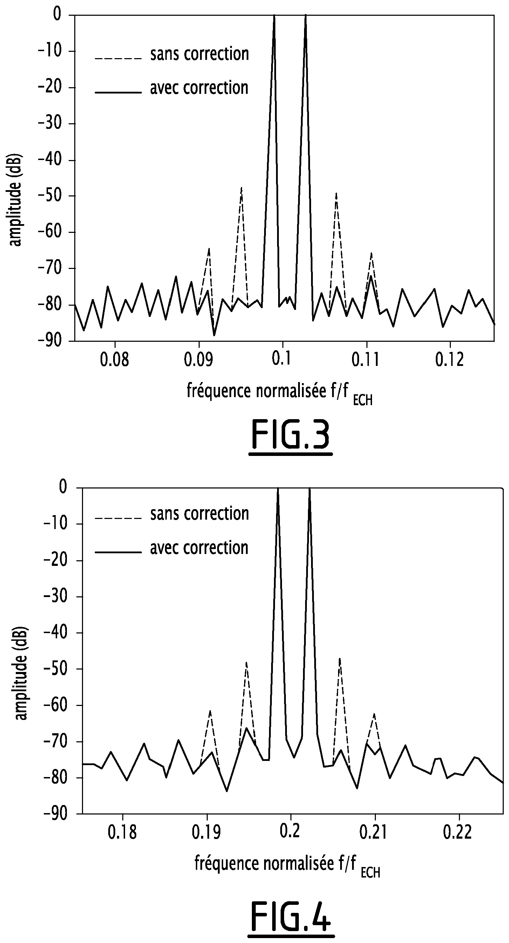

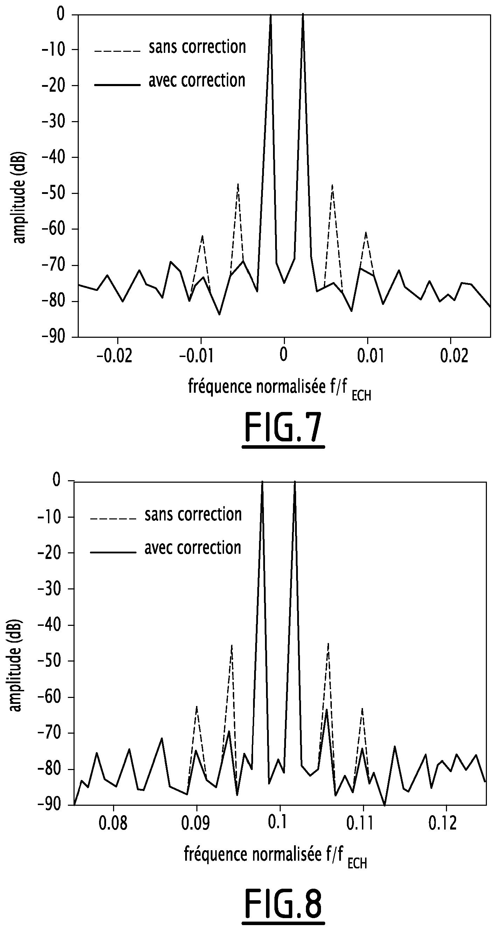

Des simulations sont représentées aux figures 3 à 10.

Les simulations qui suivent ont été réalisées à partir de séries de mesures 2 tons d'amplitudes respectives voisines de -6 dBFS (DéciBell à pleine échelle) chacune. De telles mesures ont été effectuées sur un convertisseur analogique-numérique autour de trois points de fonctionnement $f_0$ différents voisins des fréquences $2,1^*f_{ECH}$, $2.2^*f_{ECH}$ et $2.3 \, f_{ECH}$. Les deux tons séparés de $f_{ECH}/256$ étaient situés respectivement à $f_A = f_0 - f_{ECH}/512$ et $f_B = f_0 + f_{ECH}/512$ avec, suivant les cas :

- $f_0 = ( 2 + 103/1024) \times f_{ECH}$ , premier point voisin de $2.1 \, f_{ECH}$,
- $f_0 = ( 2 + 205/1024 ) \times f_{ECH}$ , second point voisin de $2.2 \, f_{ECH}$, et
- $f_0 = ( 2 + 307/1024 ) \times f_{ECH}$ , troisième point voisin de $2.3 \, f_{ECH}$

Pour chaque point de fonctionnement, quatre mesures différentes ont été effectuées correspondant à quatre conditions de phase différentes entre signaux et entre signal et horloge.

Une mesure du premier point de fonctionnement et une mesure du troisième point de calibrage sont utilisées comme mesures de calibrage pour un traitement visant à corriger les défauts jusqu'à l'ordre 5.

Plusieurs simulations du traitement calibrage/correction ont été effectuées à partir de ces mesures.

Pour les cas des figures 3 à 5, il a été effectué un traitement calibrage/correction à pleine vitesse après filtrage de Hilbert sans translation du spectre ni décimation. Pour chaque cas, les courbes représentent le maximum de l'amplitude obtenue sur les quatre mesures. Chacune des figures 3 à 5 illustrent respectivement la variation de l'amplitude en fonction de la fréquence pour les trois points de fonctionnement différents.

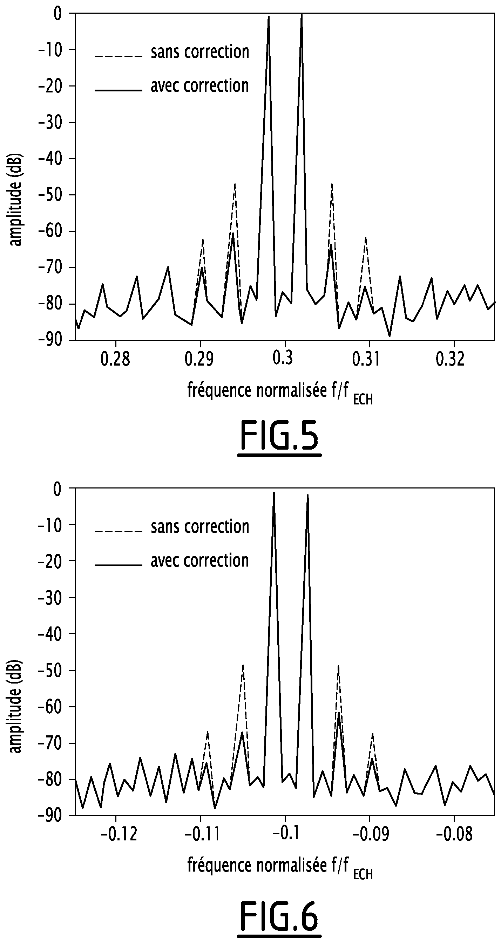

Pour les cas des figures 6 à 8, il a été effectué un traitement calibrage/correction à pleine vitesse après filtrage de Hilbert puis translation de $-205/1024 \, f_{ECH}$ mais sans décimation. Pour chaque cas, les courbes représentent le maximum de l'amplitude obtenue sur les quatre mesures. Chacune des figures 6 à 8 illustrent respectivement la variation de l'amplitude en fonction de la fréquence pour les trois points de fonctionnement différents.

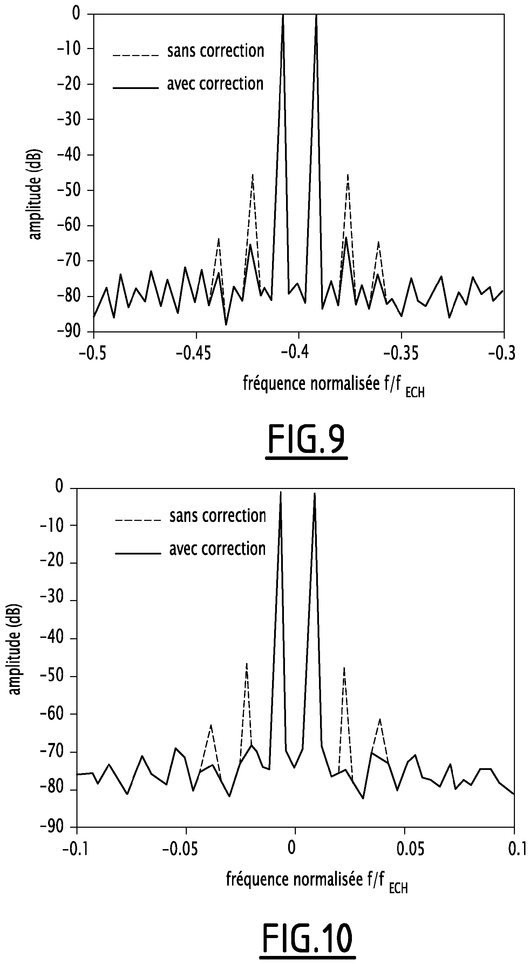

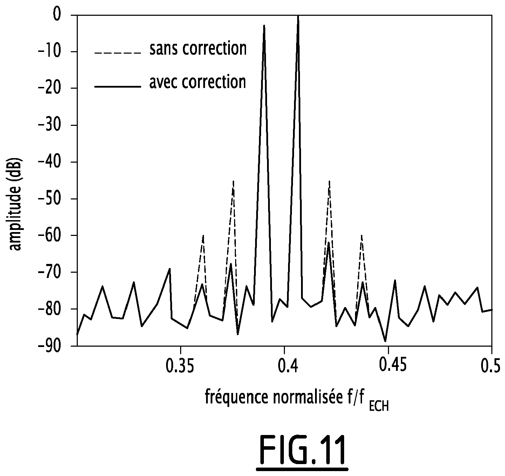

Pour les cas des figures 9 à 11, il a été effectué un traitement calibrage/correction à pleine vitesse après filtrage de Hilbert puis translation de $-205/1024 \, f_{ECH}$ avec décimation par 4. Pour chaque cas, les courbes représentent le maximum de l'amplitude obtenue sur les quatre mesures. Chacune des figures 9 à 11 illustrent respectivement la variation de l'amplitude en fonction de la fréquence pour les trois points de fonctionnement différents.

Pour les simulations, les filtres de Hilbert et de décimation utilisés sont des filtres idéaux.

Ainsi, dans le cas d'un signal répétitif, donc mesuré sur une durée finie multiple de sa période (1024 points en l'occurrence), il y a lieu de replier le filtre de dérivation dont la durée est infinie ; si N est la durée totale. Cela s'exprime mathématiquement comme :

$$h_D(n) = \frac{(-1)^n}{n} \text{ devient } \widetilde{h}_D(n) = \sum_{k=-\infty}^{+\infty} \frac{(-1)^n}{n + k \times N}$$

C'est-à-dire, en utilisant $\xi = \dfrac{n}{N}$ que l'expression précédente devient:

$$\widetilde{h}_D(n) = \frac{(-1)^n}{n} + \sum_{k=-\infty}^{-1} \frac{(-1)^n}{n + k \times N} + \sum_{k=1}^{+\infty} \frac{(-1)^n}{n + k \times N} = \frac{(-1)^n}{n} + \frac{2\xi}{N} \sum_{k=1}^{+\infty} \frac{(-1)^n}{\xi^2 - k^2} = \frac{(-1)^n}{n} + \pi \times \frac{2\pi\xi}{N} \sum_{k=1}^{+\infty} \frac{(-1)^n}{\pi^2 \xi^2 - k^2 \pi^2}$$

Or:

$$\frac{1}{\tan u} = \frac{1}{u} + 2u \sum_{k=1}^{+\infty} \frac{(-1)^n}{u^2 - k^2 \pi^2}$$

D'où :

$$\widetilde{h}_D\!\left(n\right) = \frac{\left(-1\right)^n}{n} + \frac{\left(-1\right)^n \pi}{N} \times \left(\frac{1}{\tan \pi\xi} - \frac{1}{\pi\xi}\right) = \frac{\left(-1\right)^n \pi}{N \times \tan \dfrac{\pi n}{N}}$$

*Conclusion*

Il est proposé un procédé de correction des défauts d'intermodulation d'une chaîne de réception comportant un convertisseur analogique-numérique et une chaîne de réception mettant en oeuvre un tel procédé. Le procédé permet de trouver un mécanisme de compensation travaillant sur signaux démodulés, filtrés, décimés et ne compensant que l'intermodulation sans introduire de distorsion harmonique non désirée.

Ainsi, le procédé de correction des défauts d'intermodulation introduits par un circuit de conversion permet, avec une mise en oeuvre aisée, de diminuer les défauts d'intermodulation sans générer de la distorsion harmonique non désirée.

**Revendications**

1. Procédé de correction des défauts d'intermodulation introduits par un circuit de conversion (14) adapté à convertir un signal analogique d'entrée en un signal numérique de sortie, le procédé comportant les étapes de :

    - fourniture du signal numérique de sortie,
    - génération d'une fonction de correction, la fonction de correction étant une fonction complexe du signal numérique de sortie, et
    - correction du signal numérique de sortie à l'aide de la fonction de correction, pour obtenir un signal numérique de sortie corrigé, la fonction de correction dépendant linéairement de la fréquence instantanée du signal numérique de sortie, le signal numérique de sortie corrigé étant égal à la différence entre le signal numérique de sortie et le produit du signal numérique de sortie par la fonction de correction,
    l'étape de génération de la fonction de correction comportant la mise en oeuvre d'au moins un ensemble d'étapes, chaque ensemble d'étapes étant choisi dans le groupe constitué d'un premier ensemble d'étapes, d'un deuxième ensemble d'étapes et d'un troisième ensemble d'étapes,
    le premier ensemble d'étapes comprenant les étapes de :

        - calcul d'une première fonction polynômiale du carrée du module du signal numérique de sortie, pour obtenir un premier terme final,
        - calcul d'une deuxième fonction polynômiale du carrée du module du signal numérique de sortie selon une représentation complexe, pour obtenir un deuxième terme intermédiaire,
        - application d'un filtre sur le signal numérique de sortie pour obtenir un signal filtré,
        - calcul du produit du deuxième terme intermédiaire par le produit du complexe conjugué du signal numérique de sortie par le signal filtré, pour obtenir un deuxième terme final, et
        - calcul de la somme du premier terme final et du deuxième terme final, pour obtenir la fonction de correction,

    le deuxième ensemble d'étapes comprenant les étapes de :

        - l'application d'au moins une opération au signal numérique de sortie, pour obtenir un signal de calcul,
        l'étape de correction comportant l'application de la fonction de correction au signal de calcul, et

    le troisième ensemble d'étapes comprenant les étapes de :

        - application d'un signal de calibration au circuit de conversion (14), par exemple un signal à deux fréquences distinctes,
        - mesure du signal obtenue en sortie du circuit de conversion (14), pour obtenir un signal mesuré, et
        - analyse des composantes spectrales du signal mesuré.

2. Procédé selon la revendication 1, dans lequel, l'étape de génération comporte les étapes de :

- calcul d'une première fonction polynômiale du carrée du module du signal numérique de sortie, pour obtenir un premier terme final,
- calcul d'une deuxième fonction polynômiale du carrée du module du signal numérique de sortie selon une représentation complexe, pour obtenir un deuxième terme intermédiaire,
- application d'un filtre sur le signal numérique de sortie pour obtenir un signal filtré,
- calcul du produit du deuxième terme intermédiaire par le produit du complexe conjugué du signal numérique de sortie par le signal filtré, pour obtenir un deuxième terme final, et
- calcul de la somme du premier terme final et du deuxième terme final, pour obtenir la fonction de correction.

3. Procédé selon la revendication 2, dans lequel, le filtre appliqué à l'étape d'application d'un filtre restitue la dérivée du signal numérique de sortie.

4. Procédé selon l'une quelconque des revendications 1 à 3, dans lequel l'étape de génération comporte l'application d'au moins une opération au signal numérique de sortie, pour obtenir un signal de calcul, l'étape de correction comportant l'application de la fonction de correction au signal de calcul.

5. Procédé selon la revendication 4, dans lequel au moins une opération est choisie dans le groupe constitué de:

- un filtrage de Hilbert du signal numérique de sortie,
- une démodulation numérique du signal numérique de sortie,
- un filtre à phase linéaire, et
- une décimation.

6. Procédé selon l'une quelconque des revendications 1 à 5, dans lequel l'étape de génération comporte les étapes de :

- application d'un signal de calibration au circuit de conversion (14), par exemple un signal à deux fréquences distinctes,
- mesure du signal obtenue en sortie du circuit de conversion (14), pour obtenir un signal mesuré, et
- analyse des composantes spectrales du signal mesuré.

7. Produit programme d'ordinateur comportant un support lisible d'informations, sur lequel est mémorisé un programme d'ordinateur comprenant des instructions de programme, le programme d'ordinateur étant chargeable sur une unité de traitement de données et adapté pour entraîner la mise en oeuvre d'un procédé selon l'une quelconque des revendications 1 à 6 lorsque le programme d'ordinateur est mis en oeuvre sur l'unité de traitement des données.

8. Appareil électronique (10) comportant :

- un récepteur (12) d'un signal analogique d'entrée,
- un circuit de conversion (14) adapté à convertir le signal analogique d'entrée en un signal numérique de sortie en introduisant des défauts d'intermodulation, et
- un correcteur (16) adapté à mettre en oeuvre les étapes de génération et de correction d'un procédé selon l'une quelconque des revendications 1 à 6.

9. Appareil selon la revendication 8, dans lequel le correcteur (16) est un circuit logique programmable.

**Patentansprüche**

1. - Verfahren zum Korrigieren von Intermodulationsfehlern, die von einer Umwandlungsschaltung (14) eingeführt werden, die angepasst ist, um ein analoges Eingangssignal in ein digitales Ausgangssignal umzuwandeln, das Verfahren umfassend die folgenden Schritte:

- Bereitstellen des digitalen Ausgangssignals,
- Erzeugen einer Korrekturfunktion, wobei die Korrekturfunktion eine komplexe Funktion des digitalen Ausgangssignals ist, und
- Korrigieren des digitalen Ausgangssignals mit der Korrekturfunktion, um ein korrigiertes digitales Ausgangssignal zu erlangen, wobei die Korrekturfunktion linear von der Momentanfrequenz des digitalen Ausgangssignals abhängig ist, wobei das korrigierte digitale Ausgangssignal gleich wie die Differenz zwischen dem digitalen Ausgangssignal und dem Produkt des digitalen Ausgangssignals durch die Korrekturfunktion ist, der Schritt eines Erzeugens der Korrekturfunktion umfassend das Durchführen von mindestens einem Satz von Schritten, wobei jeder Satz von Schritten ausgewählt ist aus der Gruppe von Schritten, bestehend aus einem ersten Satz von Schritten, einem zweiten Satz von Schritten und einem dritten Satz von Schritten, der erste Satz von Schritten umfassend die folgenden Schritte:

- Berechnen einer ersten Polynomfunktion des Quadrats des Moduls des digitalen Ausgangssignals, um einen ersten Endwert zu erlangen,
- Berechnen einer zweiten Polynomfunktion des Quadrats des Moduls des digitalen Ausgangssignals gemäß einer komplexen Darstellung, um einen zweiten Zwischenwert zu erlangen,
- Anwenden eines Filters auf das digitale Ausgangssignal, um ein gefiltertes Signal zu erlangen,
- Berechnen des Produkts des zweiten Zwischenwerts mit dem Produkt des konjugierten Komplexes des digitalen Ausgangssignals mit dem gefilterten Signal, um einen zweiten Endwert zu erlangen, und
- Berechnen der Summe des ersten Endwerts und des zweiten Endwerts, um die Korrekturfunktion zu erlangen,

der zweite Satz von Schritten umfassend die folgenden Schritte:

- Anwenden mindestens einer Operation auf das digitale Ausgangssignal, um ein Berechnungssignal zu erlangen, der Korrekturschritt umfassend die Anwendung der Korrekturfunktion auf das Berechnungssignal, und

der dritte Satz von Schritten umfassend die folgenden Schritte:

- Anwenden eines Kalibrierungssignals auf die Umwandlungsschaltung (14), z. B. ein Signal mit zwei unterschiedlichen Frequenzen,
- Messen des Signals, das am Ausgang der Umwandlungsschaltung (14) erlangt wird, um ein gemessenes Signal zu erlangen, und
- Analysieren der Spektralkomponenten des gemessenen Signals.

2. - Verfahren nach Anspruch 1, wobei der Erzeugungsschritt die folgenden Schritte umfasst:

- Berechnen einer ersten Polynomfunktion des Quadrats des Moduls des digitalen Ausgangssignals, um einen ersten Endwert zu erlangen,
- Berechnen einer zweiten Polynomfunktion des Quadrats des Moduls des digitalen Ausgangssignals gemäß einer komplexen Darstellung, um einen zweiten Zwischenwert zu erlangen,
- Anwenden eines Filters auf das digitale Ausgangssignal, um ein gefiltertes Signal zu erlangen,
- Berechnen des Produkts des zweiten Zwischenwerts mit dem Produkt des konjugierten Komplexes des digitalen Ausgangssignals mit dem gefilterten Signal, um einen zweiten Endwert zu erlangen, und
- Berechnen der Summe des ersten Endwerts und des zweiten Endwerts, um die Korrekturfunktion zu erlangen.

3. - Verfahren nach Anspruch 2, wobei der im Schritt des Anwendens eines Filters angewendete Filter die Ableitung des digitalen Ausgangssignals wiedergibt.

4. - Verfahren nach einem der Ansprüche 1 bis 3, wobei der Erzeugungsschritt die Anwendung mindestens einer Operation auf das digitale Ausgangssignal umfasst, um ein Berechnungssignal zu erlangen, wobei der Korrekturschritt die Anwendung der Korrekturfunktion auf das Berechnungssignal umfasst.

5. - Verfahren nach Anspruch 4, wobei mindestens eine Operation ausgewählt ist aus der Gruppe wird, bestehend aus:

- einer Hilbert-Filterung des digitalen Ausgangssignals,
- einer digitalen Demodulation des digitalen Ausgangssignals,
- einem linearen Phasenfilter und
- einer Dezimierung.

6. - Verfahren nach einem der Ansprüche 1 bis 5, wobei der Erzeugungsschritt die folgenden Schritte umfasst:

- Anwenden eines Kalibrierungssignals auf die Umwandlungsschaltung (14), z. B. ein Signal mit zwei unterschiedlichen Frequenzen,
- Messen des Signals, das am Ausgang der Umwandlungsschaltung (14) erlangt wird, um ein gemessenes Signal zu erlangen, und
- Analysieren der Spektralkomponenten des gemessenen Signals.

**7.** - Computerprogrammprodukt, umfassend einen lesbaren Informationsträger, auf dem ein Computerprogramm umfassend Programmanweisungen gespeichert ist, wobei das Computerprogramm auf eine Datenverarbeitungseinheit geladen werden kann und angepasst ist, um die Durchführung eines Verfahrens nach einem der Ansprüche 1 bis 6 zu bewirken, wenn das Computerprogramm auf der Datenverarbeitungseinheit durchgeführt wird.

**8.** - Elektronisches Gerät (10), umfassend:

- einen Empfänger (12) eines analogen Eingangssignals,
- eine Umwandlungsschaltung (14), die angepasst ist, um das analoge Eingangssignal in ein digitales Ausgangssignal umzuwandeln, indem sie Intermodulationsfehler einführt, und
- einen Korrektor (16), der angepasst ist, um die Schritte eines Erzeugens und Korrigierens eines Verfahrens nach einem der Ansprüche 1 bis 6 auszuführen.

**9.** - Vorrichtung nach Anspruch 8, wobei der Korrektor (16) eine programmierbare Logikschaltung ist.

## Claims

**1.** - A method of correcting intermodulation errors introduced by an conversion circuit (14) adapted to convert an input analogue signal to an output digital signal, the method comprising the steps of:

- providing the digital output signal,
- generating a correction function, the correction function being a complex function of the digital output signal, and
- correcting the digital output signal using the correction function to obtain a corrected digital output signal, the correction function being linearly dependent on the instantaneous frequency of the digital output signal, the corrected digital output signal being equal to the difference between the digital output signal and the product of the digital output signal and the correction function,

the step of generating the correction function comprising the implementation of at least one set of steps, each set of steps being selected from the group consisting of a first set of steps, a second set of steps and a third set of steps,

the first set of steps comprising the steps of:

- calculating a first polynomial function of the square of the modulus of the digital output signal, to obtain a first final term,
- calculating a second polynomial function of the square of the modulus of the digital output signal in a complex representation, to obtain a second intermediate term,
- applying a filter to the digital output signal to obtain a filtered signal,
- calculating the product of the second intermediate term and the product of the complex conjugate of the digital output signal and the filtered signal to obtain a second final term, and
- calculation of the sum of the first final term and the second final term, to obtain the correction function,

the second set of steps comprising the steps of:

- applying at least one operation to the digital output signal to obtain a calculation signal, the correction step comprising applying the correction function to the calculation signal, and

the third set of steps comprising the steps of:

- applying a calibration signal to the conversion circuit (14), for example a signal with two distinct frequencies,
- measuring the signal obtained at the output of the conversion circuit (14), to obtain a measured signal, and
- analysing the spectral components of the measured signal.

**2.** - The method of claim 1, wherein the method further comprises the steps of:

- calculating a first polynomial function of the square of the modulus of the digital output signal, to obtain a first final term,
- calculating a second polynomial function of the square of the modulus of the digital output signal in a complex representation, to obtain a second intermediate term,
- applying a filter to the digital output signal to obtain a filtered signal,
- calculating the product of the second intermediate term and the product of the complex conjugate of the digital output signal and the filtered signal to obtain a second final term, and
- calculating the sum of the first final term and the second final term, to obtain the correction function.

3. - The method of claim 2, wherein, the filter applied in the filter application step restores the derivative of the digital output signal.

4. - The method according to any one of claims 1 to 3, wherein the generating step comprises applying at least one operation to the digital output signal, to obtain a calculation signal, the correcting step comprising applying the correction function to the calculation signal.

5. - The method of claim 4, wherein at least one operation is selected from the group consisting of:

- a Hilbert filtering of the digital output signal,
- a digital demodulation of the digital output signal,
- a linear phase filter, and
- a decimation.

6. - The method according to any one of claims 1 to 5, wherein the method further comprises the steps of:

- applying a calibration signal to the conversion circuit (14), for example a signal with two distinct frequencies,
- measuring the signal obtained at the output of the conversion circuit (14), to obtain a measured signal, and
- analysing the spectral components of the measured signal.

7. - A computer program product comprising a readable information medium having stored thereon a computer program comprising program instructions, the computer program being loadable onto a data processing unit and adapted to cause an optimisation method according to any of claims 1 to 6 to be implemented when the computer program is implemented on the data processing unit.

8. - Electronic apparatus (10) comprising:

- a receiver (12) of an analogue input signal,
- a conversion circuit (14) adapted to convert the analogue input signal into a digital output signal by introducing intermodulation faults, and
- a corrector (16) adapted to implement the generating and correcting steps of a method according to any of claims 1 to 6.

9. - The apparatus of claim 8, wherein the corrector (16) is a programmable logic circuit.

FIG.1

FIG.2

FIG.3

FIG.4

FIG.5

FIG.6

FIG.7

FIG.8

FIG.9

FIG.10

FIG.11

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 8825415 B2
- US 5237332 A
- US 2005219089 A1